# EUROPEAN PATENT APPLICATION

(11) **EP 4 312 264 A1**
(43) Date of publication of application: **31.01.2024**
(21) Application number: 23186034.7
(22) Date of filing: 18.07.2023
(51) Int. Cl.: H01L 23/498, H01L 23/538, H01L 23/367, H01L 23/00

(54) **SEMICONDUCTOR PACKAGE**

(30) Priority: 28.07.2022 KR 20220093871
(71) Applicant: Samsung Electronics Co., Ltd., Suwon-si, Gyeonggi-do 16677 (KR)
(72) Inventor: LEE, Hyundong, 16677 Suwon-si, Gyeonggi-do (KR); KIM, Youngmin, 16677 Suwon-si, Gyeonggi-do (KR); OH, Joonseok, 16677 Suwon-si, Gyeonggi-do (KR); LEE, Sangyun, 16677 Suwon-si, Gyeonggi-do (KR); LEE, Changbo, 16677 Suwon-si, Gyeonggi-do (KR)
(74) Representative: Kuhnen & Wacker Patent- und Rechtsanwaltsbüro PartG mbB

(57) **Abstract**

A semiconductor package includes a first wiring structure including a plurality of first redistribution patterns having a plurality of first bottom connection pads and a plurality of first top connection pads and a plurality of first redistribution insulating layers surrounding the plurality of first redistribution patterns, a second wiring structure including a plurality of second redistribution patterns having a plurality of second bottom connection pads and a plurality of second top connection pads and a plurality of second redistribution insulating layers surrounding the plurality of second redistribution patterns, a semiconductor chip interposed between the first wiring structure and the second wiring structure, an encapsulant filling a space between the first wiring structure and the second wiring structure, and a plurality of connection structures passing through the encapsulant and connecting the plurality of first top connection pads to the plurality of second bottom connection pads and arranged around the semiconductor chip.

## Description

### TECHNICAL FIELD

Embodiments of the inventive concept are directed to a semiconductor package, and more particularly, to a fan-out semiconductor package.

### DISCUSSION OF THE RELATED ART

Due to technological advances and user demand, electronic devices are becoming more miniaturized and multifunctional, and larger in capacity, which need more highly integrated semiconductor chips.

Therefore, a semiconductor package that has connection terminals with secured connection reliability is designed for a highly integrated semiconductor chip in which the number of connection terminals for input and output increases. For example, to prevent interference from occurring in the connection terminals, a fan-out semiconductor package, in which a distance between the connection terminals increases, is being developed.

### SUMMARY

Embodiments of the inventive concept provide a semiconductor package with increased productivity.

According to an embodiment of the inventive concept, there is provided a semiconductor package that includes a first wiring structure that includes a plurality of first redistribution patterns that include a plurality of first bottom connection pads and a plurality of first top connection pads and a plurality of first redistribution insulating layers that surround the plurality of first redistribution patterns, a second wiring structure that includes a plurality of second redistribution patterns that include a plurality of second bottom connection pads and a plurality of second top connection pads and a plurality of second redistribution insulating layers that surround the plurality of second redistribution patterns, a semiconductor chip interposed between the first wiring structure and the second wiring structure, an encapsulant that fills a space between the first wiring structure and the second wiring structure and surrounds the semiconductor chip, and a plurality of connection structures that penetrate through the encapsulant and connect the plurality of first top connection pads to the plurality of second bottom connection pads and are arranged around the semiconductor chip. The plurality of connection structures include a plurality of lower connection structures of which bottom surfaces contact top surfaces of the plurality of first top connection pads, a plurality of upper connection structures of which top surfaces contact bottom surfaces of the plurality of second bottom connection pads, and a plurality of conductive connection layers that contact top surfaces of the plurality of lower connection structures and bottom surfaces of the plurality of upper connection structures.

According to another embodiment of the inventive concept, there is provided a semiconductor package that includes a first wiring structure that includes a plurality of first redistribution patterns that include a plurality of first bottom connection pads and a plurality of first top connection pads, and a plurality of first redistribution insulating layers that surround the plurality of first redistribution patterns, a semiconductor chip attached onto the first wiring structure, a second wiring structure disposed on the first wiring structure and the semiconductor chip, where the second wiring structure includes a plurality of second redistribution patterns that include a plurality of second bottom connection pads and a plurality of second top connection pads and a plurality of second redistribution insulating layers that surround the plurality of second redistribution patterns, a plurality of connection structures that include a plurality of lower connection structures attached to the plurality of first top connection pads, a plurality of upper connection structures attached to the plurality of second bottom connection pads, and a plurality of conductive connection layers interposed between the plurality of lower connection structures and the plurality of upper connection structures and that connect the first wiring structure to the second wiring structure, and an encapsulant that fills a space between the first wiring structure and the second wiring structure and surrounds the semiconductor chip and the plurality of connection structures. The plurality of first top connection pads protrude from top surfaces of the plurality of first redistribution insulating layers, the plurality of second bottom connection pads protrude from bottom surfaces of the plurality of second redistribution insulating layers, and the encapsulant covers side surfaces and at least a part of a top surface of each of the plurality of first top connection pads and side surfaces and at least a part of a bottom surface of each of the plurality of second bottom connection pads.

According to another embodiment of the inventive concept, there is provided a semiconductor package that includes a first wiring structure that includes a plurality of first redistribution patterns that include a plurality of first redistribution line patterns and a plurality of first redistribution via patterns and a plurality of first redistribution insulating layers that surround the plurality of first redistribution patterns, in which the plurality of first redistribution patterns include a plurality of first bottom connection pads and a plurality of first top connection pads, a second wiring structure that includes a plurality of second redistribution patterns that include a plurality of second redistribution line patterns and a plurality of second redistribution via patterns and a plurality of second redistribution insulating layers that surround the plurality of second redistribution patterns, in which the plurality of second redistribution patterns include a plurality of second bottom connection pads and a plurality of second top connection pads, a semiconductor chip interposed between the first wiring structure and the second wiring structure, a plurality of connection structures that are spaced apart from the semiconductor chip in a horizontal direction and are arranged around the semiconductor chip, where the plurality of connection structures include a plurality of lower connection structures attached to the plurality of first top connection pads, a plurality of upper connection structures attached to the plurality of second bottom connection pads, and a plurality of conductive connection layers interposed between the plurality of lower connection structures and the plurality of upper connection structures and that electrically connect the plurality of first redistribution patterns to the plurality of second redistribution patterns, and an encapsulant that fills a space between the first wiring structure and the second wiring structure and surrounds the semiconductor chip and the plurality of connection structures. The plurality of first redistribution via patterns and the plurality of second redistribution via patterns are tapered such that horizontal widths thereof increase toward the semiconductor chip.

### BRIEF DESCRIPTION OF THE DRAWINGS

FIG. 1 is a cross-sectional view of a semiconductor package according to embodiments, and FIGS. 2A, 2B, 3A, and 3B are enlarged cross-sectional views of a semiconductor package according to embodiments.
FIGS. 4A to 6D illustrate a method of manufacturing a semiconductor package according to embodiments.
FIGS. 7A to 7D illustrate a method of manufacturing a semiconductor package according to embodiments.
FIGS. 8A to 8F illustrate a method of manufacturing a semiconductor package according to embodiments.
FIGS. 9A and 9B are cross-sectional views of semiconductor packages according to embodiments.
FIGS. 10A to 10E are cross-sectional views of semiconductor packages according to embodiments.
FIG. 11 is a cross-sectional view of a semiconductor package according to embodiments.

### DETAILED DESCRIPTION

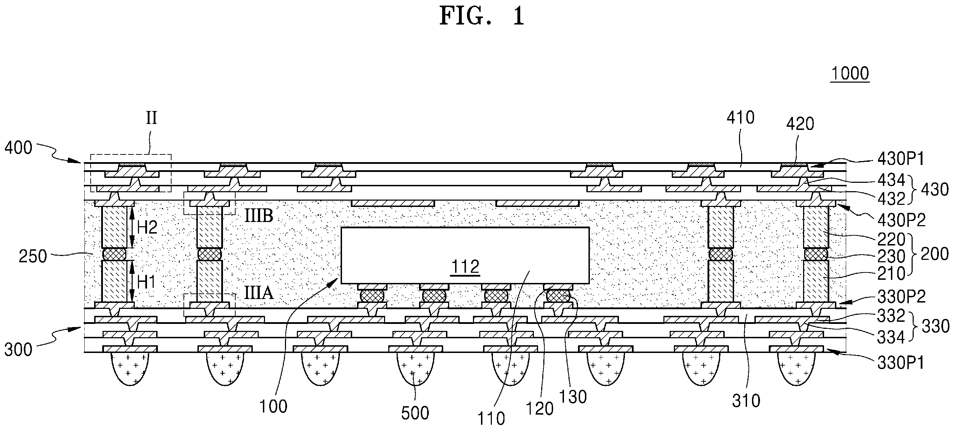

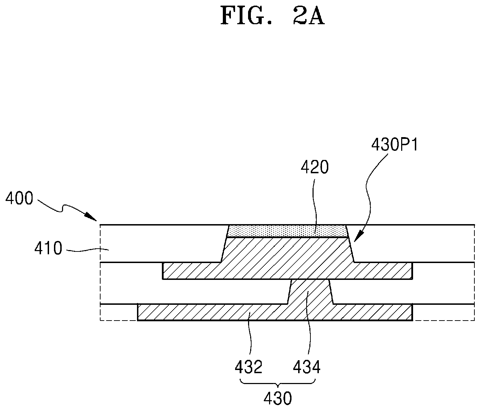

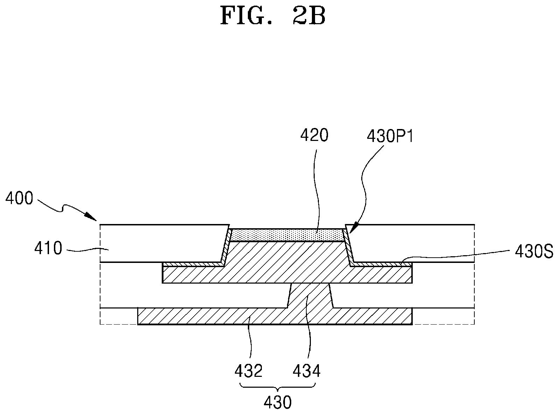

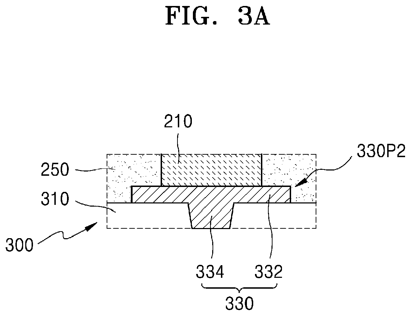

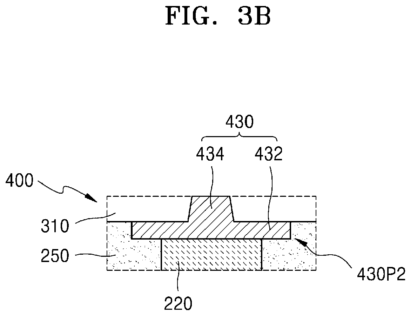

FIG. 1 is a cross-sectional view of a semiconductor package 1000 according to embodiments, and FIGS. 2A, 2B, 3A, and 3B are enlarged cross-sectional views of a semiconductor package 1000 according to embodiments. Specifically, FIGS. 2A and 2B are enlarged cross-sectional views that illustrate portion II of FIG. 1 and FIGS. 3A and 3B are enlarged cross-sectional views that illustrate portions IIIA and IIIB, respectively, of FIG. 1.

Referring to FIG. 1, the semiconductor package 1000 include a first wiring structure 300, a second wiring structure 400 disposed on the first wiring structure 300, and at least one semiconductor chip 100 disposed between the first wiring structure 300 and the second wiring structure 400. In some embodiments, the semiconductor package 1000 includes a lower package of a package-on-package (PoP). The semiconductor package 1000 includes a fan-out type semiconductor package in which a horizontal width and horizontal area of the first wiring structure 300 are greater than a horizontal width and horizontal area of a footprint formed by the at least one semiconductor chip 100. In some embodiments, the semiconductor package 1000 includes a fan-out type panel level package (FOPLP) or a fan-out type wafer level package (FOWLP).

In some embodiments, at least one of the first wiring structure 300 and the second wiring structure 400 are formed by a redistribution process. The first wiring structure 300 and the second wiring structure 400 may be referred to as a first redistribution structure and a second redistribution structure or a lower redistribution structure and an upper redistribution structure, respectively. Hereinafter, the first wiring structure 300 and the second wiring structure 400 are described as being formed by a redistribution process. However, embodiments of the inventive concept are not necessarily limited thereto. For example, in other embodiments, at least one of the first wiring structure 300 and the second wiring structure 400 includes a printed circuit board (PCB).

The first wiring structure 300 includes a plurality of first redistribution insulating layers 310 and a plurality of first redistribution patterns 330. The plurality of first redistribution insulating layers 310 surround the plurality of first redistribution patterns 330. In some embodiments, the first wiring structure 300 includes the plurality of first redistribution insulating layers 310. The plurality of first redistribution insulating layers 310 include, for example, at least one of a photoimageable dielectric (PID) and a photosensitive polyimide (PSPI). The first wiring structure 300 has a thickness of about 30 µm to about 50 µm.

The plurality of first redistribution patterns 330 include a plurality of first redistribution line patterns 332 and a plurality of first redistribution vias 334. The plurality of first redistribution patterns 330 include, for example, at least one of copper (Cu), aluminum (Al), tungsten (W), titanium (Ti), tantalum (Ta), indium (In), molybdenum (Mo), manganese (Mn), cobalt (Co), tin (Sn), nickel (Ni), magnesium (Mg), rhenium (Re), beryllium (Be), gallium (Ga), ruthenium (Ru), and an alloy of the above metals. However, embodiments of the inventive concept are not necessarily limited thereto. In some embodiments, the plurality of first redistribution patterns 330 are formed by stacking a metal or an alloy of metals on a seed layer that includes one of Cu, Ti, titanium nitride (TiN), and TiW.

Each of the plurality of first redistribution line patterns 332 is disposed on at least one of a top surface and a bottom surface of each of the plurality of first redistribution insulating layers 310. For example, when the first wiring structure 300 includes the plurality of first redistribution insulating layers 310, the plurality of first redistribution line patterns 332 may be disposed on a top surface of the uppermost first redistribution insulating layer 310, on a bottom surface of the lowermost first redistribution insulating layer 310, or between two neighboring first redistribution insulating layers 310.

The plurality of first redistribution vias 334 penetrate through at least one first redistribution insulating layer 310 and are connected to some of the plurality of first redistribution line patterns 332. In some embodiments, the plurality of first redistribution vias 334 are tapered such that horizontal widths thereof increase from bottom to top. For example, the horizontal widths of the plurality of first redistribution vias 334 increase toward the at least one semiconductor chip 100.

In some embodiments, at least some of the plurality of first redistribution line patterns 332 are formed together with some of the plurality of first redistribution vias 334 to be integrated with some of the plurality of first redistribution vias 334. For example, the plurality of first redistribution line patterns 332 are formed together with the plurality of first redistribution vias 334 that contact bottom surfaces of the plurality of first redistribution line patterns 332 to be integrated with the plurality of first redistribution vias 334 that contact the bottom surfaces of the plurality of first redistribution line patterns 332. For example, the horizontal widths of the plurality of first redistribution vias 334 decrease away from the plurality of first redistribution line patterns 332 integrated with the plurality of first redistribution vias 334.

Of the plurality of first redistribution patterns 330, those adjacent to a bottom surface of the first wiring structure 300 may be referred to as a plurality of first bottom connection pads 330P1, and those adjacent to a top surface of the first wiring structure 300 may be referred to as a plurality of first top connection pads 330P2. For example, the plurality of first bottom connection pads 330P1 include those first redistribution line patterns 332 adjacent to the bottom surface of the first wiring structure 300, and the plurality of first top connection pads 330P2 include those first redistribution line patterns 332 adjacent to the top surface of the first wiring structure 300.

A plurality of external connection terminals 500 are attached to the plurality of first bottom connection pads 330P1. The plurality of external connection terminals 500 connect the semiconductor package 1000 to an outside device. In some embodiments, the plurality of external connection terminals 500 include bumps or solder balls. For example, each of the plurality of external connection terminals 500 has a height of about 100 µm to about 180 µm. A plurality of chip connection members 130 are attached to some of the plurality of first top connection pads 330P2, and a plurality of connection structures 200 are attached to others of the plurality of first top connection pads 330P2. For example, a plurality of lower connection structures 210 are attached to others of the plurality of first top connection pads 330P2.

The plurality of first top connection pads 330P2 are disposed on the top surface of the uppermost first redistribution insulating layer 310. For example, when the first wiring structure 300 includes the plurality of stacked first redistribution insulating layers 310, the plurality of first top connection pads 330P2 are disposed on the top surface of the uppermost first redistribution insulating layer 310. The plurality of first top connection pads 330P2 protrude in a vertical direction from the top surface of the uppermost first redistribution insulating layer 310 toward the semiconductor chip 100. A top surface and at least parts of side surfaces of each of the plurality of first top connection pads 330P2 do not contact the uppermost first redistribution insulating layer 310. The plurality of first bottom connection pads 330P1 do not protrude in the vertical direction from the bottom surface of the lowermost first redistribution insulating layer 310. In some embodiments, bottom surfaces of the plurality of first bottom connection pads 330P1 and the bottom surface of the lowermost first redistribution insulating layer 310 are coplanar.

The at least one semiconductor chip 100 is attached onto the first wiring structure 300. The semiconductor chip 100 includes a semiconductor substrate 110 that includes an active surface and an inactive surface opposite to each other, a semiconductor device 112 formed on the active surface of the semiconductor substrate 110, and a plurality of chip pads 120 disposed on a first surface of the semiconductor chip 100. The semiconductor chip 100 has a thickness of about 70 µm to about 120 µm. In the current specification, the first surface of the semiconductor chip 100 and a second surface of the semiconductor chip 100 are opposite to each other, and the second surface of the semiconductor chip 100 is the inactive surface of the semiconductor substrate 110. Because the active surface of the semiconductor substrate 110 is very close to the first surface of the semiconductor chip 100, the active surface of the semiconductor substrate 110 is not illustrated as being separate from the first surface of the semiconductor chip 100.

In some embodiments, the semiconductor chip 100 has a face down arrangement in which the first surface thereof faces the first wiring structure 300 and is attached to the top surface of the first wiring structure 300. The first surface of the semiconductor chip 100 may be referred to as a bottom surface of the semiconductor chip 100, and the second surface of the semiconductor chip 100 may be referred to as a top surface of the semiconductor chip 100. Unless otherwise specified in the current specification, the top surface refers to a surface facing upward in the drawing, and the bottom surface refers to a surface facing downward in the drawing.

The plurality of chip connection members 130 are interposed between the plurality of chip pads 120 of the semiconductor chip 100 and the plurality of first top connection pads 330P2 of the first wiring structure 300. The plurality of chip connection members 130 include solder balls or microbumps. The semiconductor chip 100 is electrically connected to the plurality of first redistribution patterns 330 of the first wiring structure 300 through the plurality of chip connection members 130.

The semiconductor substrate 110 includes, for example, a semiconductor material such as one of silicon (Si) and germanium (Ge). Alternatively, the semiconductor substrate 110 includes a compound semiconductor material such as at least one of silicon carbide (SiC), gallium arsenide (GaAs), indium arsenide (InAs), and indium phosphide (InP). The semiconductor substrate 110 includes a conductive region, such as a well doped with impurities. The semiconductor substrate 110 includes at least one device isolation structure, such as a shallow trench isolation (STI) structure.

The semiconductor device 112 includes a plurality of various kinds of individual devices and is formed on the active surface of the semiconductor substrate 110. The plurality of individual devices include various microelectronic devices, such as a metal-oxide-semiconductor field effect transistor (MOSFET) such as a complementary metal-oxide-semiconductor (CMOS) transistor, a system large scale integration (LSI), an active device, or a passive device. The plurality of individual devices are electrically connected to the conductive region of the semiconductor substrate 110. The semiconductor device 112 further includes at least two of the plurality of individual devices, or a conductive wire or a conductive plug that electrically connects the plurality of individual devices to the conductive region of the semiconductor substrate 110. In addition, each of the plurality of individual devices is electrically isolated from a neighboring individual device by an insulating layer.

In some embodiments, the semiconductor chip 100 includes a logic element. For example, the semiconductor chip 100 includes at least one of a central processing unit (CPU) chip, a graphics processing unit (GPU) chip, and an application processor (AP) chip. In other embodiments, when the semiconductor package 1000 includes a plurality of semiconductor chips 100, at least one of the plurality of semiconductor chips 100 includes the CPU chip, the GPU chip, or the AP chip, and at least one of the plurality of semiconductor chips 100 includes a memory semiconductor chip that includes a memory device. For example, the memory device includes a non-volatile memory device such as at least one of a flash memory, a phase-change random access memory (PRAM), a magnetoresistive random access memory (MRAM), a ferroelectric random access memory (FeRAM), and a resistive random access memory (RRAM). The flash memory includes, for example, NAND flash memory or a V-NAND flash memory. In some embodiments, the memory device includes a volatile memory device such as a dynamic random access memory (DRAM) or a static random access memory (SRAM).

The second wiring structure 400 includes a plurality of second redistribution insulating layers 410 and a plurality of second redistribution patterns 430. The plurality of second redistribution insulating layers 410 surround the plurality of second redistribution patterns 430. The plurality of second redistribution insulating layers 410 include, for example, PID or PSPI.

In some embodiments, a thickness of the second wiring structure 400 is less than that of the first wiring structure 300. For example, the second wiring structure 400 has a thickness of about 20 µm to about 40 µm. In some embodiments, the second wiring structure 400 includes the plurality of second redistribution insulating layers 410. The plurality of second redistribution patterns 430 includes a plurality of second redistribution line patterns 432 and a plurality of second redistribution vias 434. The plurality of second redistribution patterns 430 includes a metal or an alloy of metals. However, embodiments of the inventive concept are not necessarily limited thereto. In some embodiments, the plurality of second redistribution patterns 430 are formed by stacking a metal or an alloy of metals on a seed layer.

The plurality of second redistribution line patterns 432 are disposed on at least one of a top surface and a bottom surface of each of the plurality of second redistribution insulating layers 410. For example, when the second wiring structure 400 includes the plurality of second redistribution insulating layers 410, the plurality of second redistribution line patterns 432 may be arranged on a top surface of the uppermost second redistribution insulating layer 410, on a bottom surface of the lowermost second redistribution insulating layer 410, or between two neighboring second redistribution insulating layers 410.

Of the plurality of second redistribution patterns 430, those adjacent to a top surface of the second wiring structure 400 may be referred to as a plurality of second top connection pads 430P1, and those adjacent to a bottom surface of the second wiring structure 400 may be referred to as a plurality of second bottom connection pads 430P2. For example, the plurality of second top connection pads 430P1 include those second redistribution vias 434 adjacent to the top surface of the second wiring structure 400, and the plurality of second bottom connection pads 430P2 include those second redistribution line patterns 432 adjacent to the bottom surface of the second wiring structure 400.

In some embodiments, a plurality of conductive protective layers 420 are arranged on those of the plurality of second redistribution patterns 430 that are adjacent to the top surface of the second wiring structure 400. For example, the plurality of conductive protective layers 420 are arranged on those of the plurality of second redistribution vias 434 that are adjacent to the top surface of the second wiring structure 400, respectively. The plurality of conductive protective layers 420 include at least one of gold (Au), Ni, and a stacked structure thereof. The plurality of conductive protective layers 420 cover top surfaces of the plurality of second redistribution patterns 430, so that those of the plurality of second redistribution patterns 430 that are adjacent to the top surface of the second wiring structure 400 are not externally exposed. The plurality of conductive protective layers 420 cover top surfaces of the plurality of second top connection pads 430P1. Alternatively, the plurality of conductive protective layers 420 are parts of the plurality of second top connection pads 430P1, such as upper parts of the plurality of second top connection pads 430P1. For example, lower parts of the plurality of second top connection pads 430P1 include the plurality of second redistribution patterns 430 adjacent to the top surface of the second wiring structure 400 and the upper parts of the plurality of second top connection pads 430P1 include the plurality of conductive protective layers 420.

In some embodiments, when the semiconductor package 1000 is a lower package of the PoP, an upper package is connected to the plurality of second top connection pads 430P1. For example, a plurality of package connection terminals are interposed between the upper package and the plurality of second top connection pads 430P1. In some embodiments, the plurality of package connection terminals include bumps or solder balls. The upper package includes an auxiliary semiconductor chip. The auxiliary semiconductor chip may include a memory semiconductor chip. For example, the auxiliary semiconductor chip includes at least one of a DRAM chip, an SRAM chip, a flash memory chip, an electrically erasable programmable read-only memory (EEPROM) chip, a PRAM chip, an MRAM chip, and an RRAM chip. The plurality of connection structures 200 are attached to the plurality of second bottom connection pads 430P2.

The plurality of second bottom connection pads 430P2 are disposed on the bottom surface of the lowermost second redistribution insulating layer 410. For example, when the second wiring structure 400 includes the plurality of second redistribution insulating layers 410, the plurality of second bottom connection pads 430P2 are disposed on the bottom surface of the lowermost second redistribution insulating layer 410. The plurality of second bottom connection pads 430P2 protrude in the vertical direction from the bottom surface of the lowermost second redistribution insulating layer 410 toward the semiconductor chip 100. A bottom surface and at least parts of side surfaces of each of the plurality of second bottom connection pads 430P2 do not contact the lowermost second redistribution insulating layer 410. The plurality of second top connection pads 430P1 do not protrude from the top surface of the uppermost second redistribution insulating layer 410 in the vertical direction. In some embodiments, the top surfaces of the plurality of second top connection pads 430P1 and the top surface of the uppermost second redistribution insulating layer 410 are coplanar. In other embodiments, the top surfaces of the plurality of second top connection pads 430P1 are recessed from the top surface of the uppermost second redistribution insulating layer 410.

The plurality of second redistribution vias 434 penetrate through at least one second redistribution insulating layer 410 and are connected to some of the plurality of second redistribution line patterns 432. In some embodiments, at least some of the plurality of second redistribution line patterns 432 are formed together with some of the plurality of second redistribution vias 434 to be integrated with some of the plurality of second redistribution vias 434. For example, the plurality of second redistribution line patterns 432 are formed together with the plurality of second redistribution vias 434 that contact top surfaces of the plurality of second redistribution line patterns 432 to be integrated with the plurality of second redistribution vias 434 that contacts the top surfaces of the plurality of second redistribution line patterns 432.

In some embodiments, the plurality of second redistribution vias 434 are tapered such that horizontal widths thereof increase from top to bottom. For example, the horizontal widths of the plurality of second redistribution vias 434 increase toward the at least one semiconductor chip 100. The plurality of first redistribution vias 334 and the plurality of second redistribution vias 434 are tapered such that the horizontal widths thereof increase or decrease in directions opposite to each other in the vertical direction. For example, the horizontal widths of the plurality of first redistribution vias 334 and the plurality of second redistribution vias 434 may increase as the plurality of first redistribution vias 334 are closer to the plurality of second redistribution vias 434, and decrease as the plurality of first redistribution vias 334 are farther away from the plurality of second redistribution vias 434.

An encapsulant 250 surrounds the semiconductor chip 100 on the top surface of the first wiring structure 300. The encapsulant 250 fills a space between the first wiring structure 300 and the second wiring structure 400. The encapsulant 250 has a thickness of about 150 µm to about 200 µm. The encapsulant 250 includes a molding member that includes an epoxy mold compound (EMC). The encapsulant 250 may include a filler. For example, the filler includes a ceramic-based material that has non-conductive insulating properties. In some embodiments, the filler includes at least one of AlN, BN, Al₂O₃, SiC, and MgO. For example, the filler includes a silica filler or an alumina filler. For example, the encapsulant 250 includes an epoxy-based material that includes a filler. An average diameter of filler particles in the encapsulant 250 is about 3 µm to about 50 µm. A ratio of the filler in the encapsulant 250 is about 60 wt% to about 90 wt%.

In some embodiments, the encapsulant 250 has a molded under-fill (MUF) structure that fills a space between the bottom surface of the semiconductor chip 100 and the top surface of the first wiring structure 300 and that surrounds the plurality of chip connection members 130. In other embodiments, an underfill layer that surrounds the plurality of chip connection members 130 is interposed between the semiconductor chip 100 and the first wiring structure 300. The underfill layer includes, for example, an epoxy resin formed by a capillary underfill method. In some embodiments, the underfill layer includes a non-conductive film (NCF).

In some embodiments, side surfaces of the first wiring structure 300, side surfaces of the encapsulant 250, and side surfaces of the second wiring structure 400 are aligned with each other in the vertical direction. For example, one side of the first wiring structure 300, one side of the encapsulant 250, and one side of the second wiring structure 400 that correspond to each other are coplanar.

The plurality of connection structures 200 electrically connect the first wiring structure 300 to the second wiring structure 400 through the encapsulant 250. The plurality of connection structures 200 are interposed between the first wiring structure 300 and the second wiring structure 400 and are spaced apart from the at least one semiconductor chip 100 in a horizontal direction. For example, the plurality of connection structures 200 are spaced apart from the at least one semiconductor chip 100 in the horizontal direction and are arranged around the at least one semiconductor chip 100. The plurality of connection structures 200 are interposed between the plurality of first top connection pads 330P2 and the plurality of second bottom connection pads 430P2. Bottom surfaces of the plurality of connection structures 200 contact the plurality of first top connection pads 330P2 of the first wiring structure 300 to be electrically connected to the plurality of first redistribution patterns 330, and top surfaces of the plurality of connection structures 200 contact the plurality of second bottom connection pads 430P2 of the second wiring structure 400 to be electrically connected to the plurality of second redistribution patterns 430. A height of each of the plurality of connection structures 200 is about 150 µm to about 200 µm.

The plurality of connection structures 200 include the plurality of lower connection structures 210, a plurality of upper connection structures 220, and a plurality of conductive connection layers 230. The plurality of conductive connection layers 230 are interposed between the plurality of lower connection structures 210 and the plurality of upper connection structures 220 and electrically connect the plurality of lower connection structures 210 to the plurality of upper connection structures 220.

For example, each of the plurality of lower connection structures 210 and each of the plurality of upper connection structures 220 includes one of a conductive pillar, a through mold via (TMV), and a conductive solder. In some embodiments, each of the plurality of lower connection structures 210 and each of the plurality of upper connection structures 220 includes a conductive post that includes Cu or a Cu alloy. For example, each of the plurality of conductive connection layers 230 includes a conductive solder. The plurality of conductive connection layers 230 contact top surfaces of the plurality of lower connection structures 210 and bottom surfaces of the plurality of upper connection structures 220. In other embodiments, when each of the plurality of lower connection structures 210 and each of the plurality of upper connection structures 220 includes a TMV or a conductive solder, the plurality of connection structures 200 includes the plurality of lower connection structures 210 and the plurality of upper connection structures 220 but not the plurality of conductive connection layers 230, and the top surfaces of the plurality of lower connection structures 210 directly contact the bottom surfaces of the plurality of upper connection structures 220.

The plurality of lower connection structures 210 are attached onto the plurality of first top connection pads 330P2 of the first wiring structure 300. For example, bottom surfaces of the plurality of lower connection structures 210 contact top surfaces of the plurality of first top connection pads 330P2. The plurality of upper connection structures 220 are attached onto the plurality of second bottom connection pads 430P2 of the second wiring structure 400. For example, top surfaces of the plurality of upper connection structures 220 contact bottom surfaces of the plurality of second bottom connection pads 430P2. The encapsulant 250 covers side surfaces of the plurality of lower connection structures 210, the plurality of upper connection structures 220, and the plurality of conductive connection layers 230.

After attaching the at least one semiconductor chip 100 onto the first wiring structure 300, the second wiring structure 400 to which the plurality of upper connection structures 220 are attached is attached onto the first wiring structure 300 to which the plurality of lower connection structures 210 are attached. The second wiring structure 400 is attached onto the first wiring structure 300 such that each of the plurality of lower connection structures 210 and corresponding one of the plurality of upper connection structures 220 are connected to each other with each of the plurality of conductive connection layers 230 therebetween. Then, the encapsulant 250 is injected between the first wiring structure 300 and the second wiring structure 400 to form the semiconductor package 1000.

Each of the plurality of lower connection structures 210 has a first height H1 in the vertical direction, and each of the plurality of upper connection structures 220 has a second height H2 in the vertical direction. The first height H1 is substantially equal to the second height H2. At least a part of each of the plurality of conductive connection layers 230 is at the same vertical level as that of the semiconductor chip 100. In some embodiments, a top surface of each of the plurality of conductive connection layers 230 is located at a vertical level lower than that of the top surface of the semiconductor chip 100, and a bottom surface of each of the plurality of conductive connection layers 230 is located at a vertical level higher than that of the bottom surface of the semiconductor chip 100. In other embodiments, one of the top surface and the bottom surface of each of the plurality of conductive connection layers 230 is located at a vertical level between the top surface and the bottom surface of the semiconductor chip 100, and the other of the top surface and the bottom surface of each of the plurality of conductive connection layers 230 is located at a vertical level higher than the top surface of the semiconductor chip 100 or lower than the bottom surface of the semiconductor chip 100.

Referring to FIGS. 1 and 2A, in an embodiment, the second wiring structure 400 includes the plurality of second redistribution insulating layers 410, the plurality of conductive protective layers 420, and the plurality of second redistribution patterns 430. The plurality of second redistribution insulating layers 410 surround the plurality of conductive protective layers 420 and the plurality of second redistribution patterns 430. The plurality of second redistribution patterns 430 include a plurality of second redistribution line patterns 432 and a plurality of second redistribution vias 434.

Those of the plurality of second redistribution patterns 430 that are adjacent to the top surface of the second wiring structure 400 may be referred to as the plurality of second top connection pads 430P1. For example, the plurality of second top connection pads 430P1 include those second redistribution vias 434 adjacent to the top surface of the second wiring structure 400. Alternatively, the plurality of second redistribution patterns 430 adjacent to the top surface of the second wiring structure 400, which include the plurality of second redistribution vias 434, and the plurality of conductive protective layers 420 that cover top surfaces of the plurality of second redistribution vias 434, may be referred to as the plurality of second top connection pads 430P1.

The plurality of conductive protective layers 420 cover the top surfaces of those of the plurality of second redistribution patterns 430 that are adjacent to the top surface of the second wiring structure 400. For example, the plurality of conductive protective layers 420 cover the top surfaces of those of the plurality of second redistribution vias 434 that are adjacent to the top surface of the second wiring structure 400. In some embodiments, the top surface of the uppermost second redistribution insulating layer 410 and top surfaces of the plurality of conductive protective layers 420 are at the same vertical level and are coplanar.

Referring to FIGS. 1 and 2B, in an embodiment, the second wiring structure 400 includes the plurality of second redistribution insulating layers 410, the plurality of conductive protective layers 420, and the plurality of second redistribution patterns 430. The plurality of conductive protective layers 420 cover the top surfaces of those of the plurality of second redistribution patterns 430 that are adjacent to the top surface of the second wiring structure 400.

The second wiring structure 400 further includes a plurality of redistribution seed layers 430S interposed between at least some of the plurality of second redistribution patterns 430 and the plurality of second redistribution insulating layers 410, and between the plurality of conductive protection layers 420 and the plurality of second redistribution insulating layers 410. The plurality of redistribution seed layers 430S include, for example, at least one of Cu, Al, W, Ti, Ta, In, Mo, Mn, Co, Sn, Ni, Mg, Re, Be, Ga, Ru, and an alloy of the above metals. For example, the plurality of redistribution seed layers 430S includes Cu.

The plurality of redistribution seed layers 430S extend between the uppermost second redistribution insulating layer 410 and those of the plurality of second redistribution patterns 430 that are adjacent thereto, and between the uppermost second redistribution insulating layer 410 and the plurality of conductive protection layers 420.

In some embodiments, a vertical level of the top surface of each of the plurality of conductive protective layers 420 is lower than that of the top surface of the uppermost second redistribution insulating layer 410. That is, the top surfaces of the plurality of conductive protective layers 420 or the top surfaces of the plurality of second top connection pads 430P1 are recessed from the top surface of the uppermost second redistribution insulating layer 410. In the vertical direction, a distance between the top surface of each of the plurality of conductive protective layers 420 and the top surface of the uppermost second redistribution insulating layer 410 is substantially equal to a thickness of each of the plurality of redistribution seed layers 430S.

Referring to FIGS. 1, 3A, and 3B, in an embodiment, the plurality of first top connection pads 330P2 protrude in the vertical direction from the top surface of the uppermost first redistribution insulating layer 310 toward the semiconductor chip 100. For example, when the first wiring structure 300 includes the plurality of stacked first redistribution insulating layers 310, the plurality of first top connection pads 330P2 protrude in the vertical direction from the top surface of the uppermost first redistribution insulating layer 310 toward the semiconductor chip 100. A top surface and at least parts of side surfaces of each of the plurality of first top connection pads 330P2 are not in contact with the uppermost first redistribution insulating layer 310. The encapsulant 250 covers the side surfaces and at least a part of the top surface of each of the plurality of first top connection pads 330P2.

The lower connection structure 210 is attached to the top surface of the first top connection pad 330P2. A vertical level of the bottom surface of each of the plurality of lower connection structures 210 is higher than that of a bottom surface of the encapsulant 250.

The plurality of second bottom connection pads 430P2 protrude in the vertical direction from the bottom surface of the lowermost second redistribution insulating layer 410 toward the semiconductor chip 100. For example, when the second wiring structure 400 includes the plurality of second redistribution insulating layers 410, the plurality of second bottom connection pads 430P2 protrude in the vertical direction from the bottom surface of the lowermost second redistribution insulating layer 410 toward the semiconductor chip 100. A bottom surface and at least parts of side surfaces of each of the plurality of second bottom connection pads 430P2 are not in contact with the lowermost second redistribution insulating layer 410. The encapsulant 250 covers the side surfaces and at least a part of the bottom surface of each of the plurality of second bottom connection pads 430P2.

The plurality of upper connection structures 220 are attached onto the plurality of second bottom connection pads 430P2. A vertical level of the top surface of the each of the plurality of upper connection structures 220 is lower than that of a top surface of the encapsulant 250.

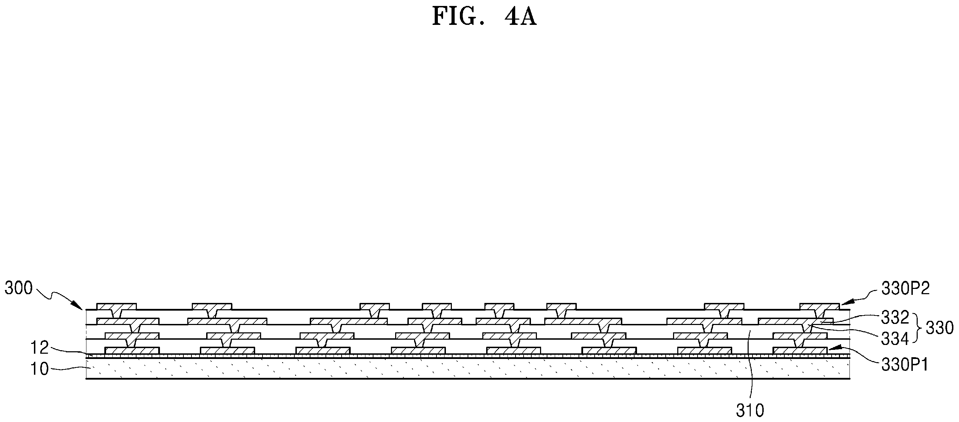

FIGS. 4A to 6D are cross-sectional views that illustrate a method of manufacturing a semiconductor package 1000 according to embodiments.

Referring to FIG. 4A, in an embodiment, the first wiring structure 300, which includes the plurality of first redistribution insulating layers 310 and the plurality of first redistribution patterns 330, which include the plurality of first redistribution line patterns 332 and the plurality of first redistribution vias 334, is formed on a first support substrate 10. A first base layer 12 is interposed between the first support substrate 10 and the first wiring structure 300. For example, after the first base layer 12 is formed on the first support substrate 10, the first wiring structure 300 is formed on the first base layer 12. The first support substrate 10 is one or more of a semiconductor substrate, a glass substrate, a ceramic substrate, and a plastic substrate. The first base layer 12 includes a seed layer that forms the plurality of first redistribution patterns 330. However, embodiments of the inventive concept are not necessarily limited thereto. In some embodiments, the first base layer 12 includes a release film.

The plurality of first redistribution line patterns 332 are formed on the first support substrate 10. The plurality of first redistribution line patterns 332 include the plurality of first bottom connection pads 330P1. After forming a first preliminary redistribution insulating layer, an exposure process is performed that removes parts of the first preliminary redistribution insulating layer and forms the plurality of first redistribution insulating layers 310 and a plurality of first via holes. Horizontal widths of the plurality of first via holes decrease from the top surfaces of the plurality of first redistribution insulating layers 310 toward the bottom surfaces of the plurality of first redistribution insulating layers 310. After forming a plurality of first redistribution conductive layers on the plurality of first redistribution insulating layers 310, the plurality of first redistribution conductive layers are patterned to form the plurality of first redistribution patterns 330, which include the plurality of first redistribution line patterns 332 and the plurality of first redistribution vias 334. The plurality of first redistribution vias 334 fill the plurality of first via holes in the plurality of first redistribution insulating layers 310, and the plurality of first redistribution line patterns 332 are disposed on the top surfaces of the plurality of first redistribution insulating layers 310. Then, the first wiring structure 300 is fabricated by repeatedly forming the plurality of first redistribution insulating layers 310 and the plurality of first redistribution patterns 330.

The plurality of first redistribution vias 334 are formed such that horizontal widths thereof decrease from the top surfaces of the plurality of first redistribution insulating layers 310 toward the bottom surfaces of the plurality of first redistribution insulating layers 310. Because the plurality of first redistribution patterns 330 are formed by patterning the plurality of first redistribution conductive layers, at least some of the plurality of first redistribution line patterns 332 formed on the plurality of first redistribution insulating layers 310 and the plurality of first via holes are integrated with at least some of the plurality of first redistribution vias 334.

In some embodiments, the bottom surfaces of the plurality of first bottom connection pads 330P1 and the bottom surface of the lowermost first redistribution insulating layer 310 are coplanar. In some embodiments, the plurality of first top connection pads 330P2 protrude from the top surface of the uppermost first redistribution insulating layer 310.

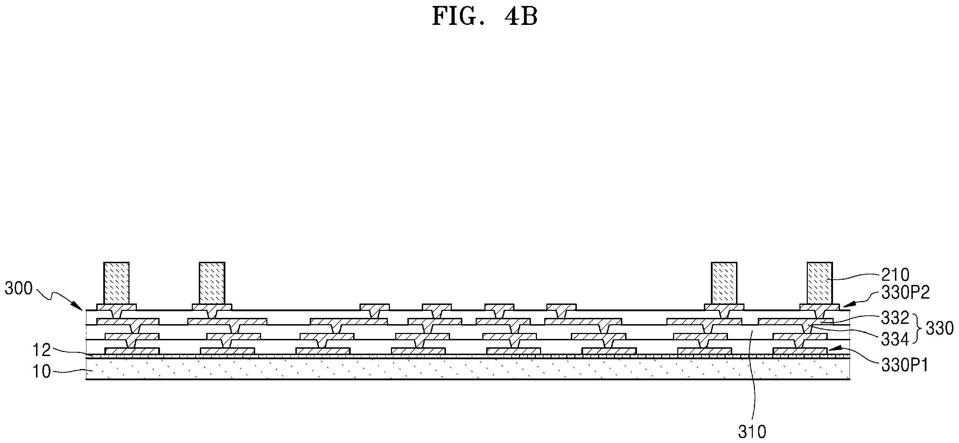

Referring to FIG. 4B, in an embodiment, the plurality of lower connection structures 210 are formed on some of the plurality of first top connection pads 330P2. In some embodiments, the plurality of lower connection structures 210 are obtained by forming a mask pattern that exposes parts of some of the plurality of first top connection pads 330P2 on the first wiring structure 300, and performing a plating process on the exposed parts of some of the plurality of first top connection pads 330P2. After forming the plurality of lower connection structures 210, the mask pattern is removed.

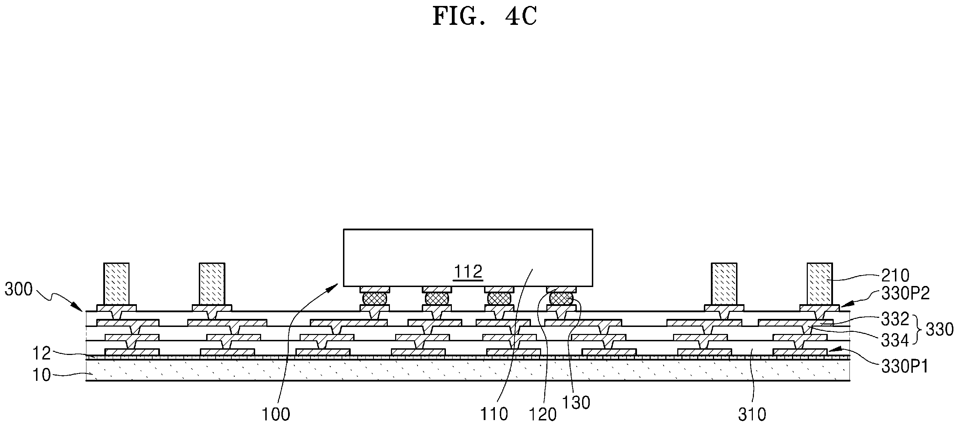

Referring to FIG. 4C, in an embodiment, the semiconductor chip 100 and the plurality of chip pads 120 are attached onto the first wiring structure 300. The semiconductor chip 100 is attached onto the first wiring structure 300 such that the plurality of chip connection members 130 are interposed between the plurality of chip pads 120 and others of the plurality of first top connection pads 330P2 of the first wiring structure 300. The semiconductor chip 100 is attached onto the first wiring structure 300 and spaced apart from the plurality of connection structures 200 in the horizontal direction.

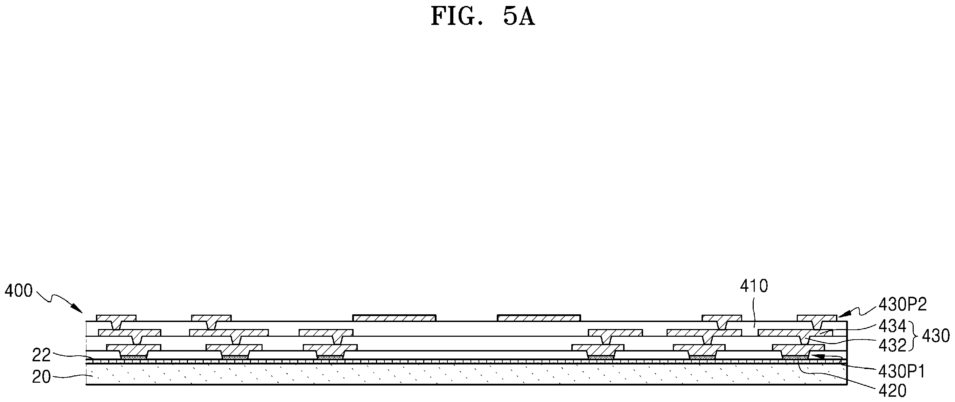

Referring to FIG. 5A, in an embodiment, in addition to the first wiring structure 300 illustrated in FIG. 4A, the second wiring structure 400, which includes the plurality of second redistribution insulating layers 410 and the plurality of second redistribution patterns 430, which includes the plurality of second redistribution line patterns 432 and the plurality of second redistribution vias 434, is formed on a second support substrate 20. A second base layer 22 is interposed between the second support substrate 20 and the second wiring structure 400. Because the second support substrate 20 and the second base layer 22 are substantially the same as the first support substrate 10 and the first base layer 12 described in FIG. 4A, detailed description thereof will be omitted.

After forming a second preliminary redistribution insulating layer on the second support substrate 20, an exposure process is performed that removes parts of the second preliminary redistribution insulating layer and forms the plurality of second redistribution insulating layers 410 and a plurality of second via holes. The plurality of second via holes are formed such that horizontal widths thereof decrease from the top surfaces of the plurality of second redistribution insulating layers 410 toward the bottom surfaces of the plurality of second redistribution insulating layers 410. After forming a plurality of second redistribution conductive layers on the plurality of second redistribution insulating layers 410, the plurality of second redistribution conductive layers are patterned to form the plurality of second redistribution patterns 430, which include the plurality of second redistribution line patterns 432 and the plurality of second redistribution vias 434. The plurality of second redistribution vias 434 formed on the second support substrate 20 include the plurality of second top connection pads 430P1. The plurality of second redistribution vias 434 fill the plurality of second via holes in the plurality of second redistribution insulating layers 410, and the plurality of second redistribution line patterns 432 are disposed on the top surfaces of the plurality of second redistribution insulating layers 410. The plurality of second redistribution vias 434 are formed such that horizontal widths thereof decrease from the top surfaces of the plurality of second redistribution insulating layers 410 toward the bottom surfaces of the plurality of second redistribution insulating layers 410. Because the plurality of second redistribution patterns 430 are formed by patterning the plurality of second redistribution conductive layers, at least some of the plurality of second redistribution line patterns 432 are integrated with at least some of the plurality of second redistribution vias 434.

After forming the plurality of second redistribution insulating layers 410 on the second support substrate 20, before forming the plurality of second redistribution patterns 430, the plurality of conductive protective layers 420 that partially fill lower sides of the plurality of second via holes are formed, and then the plurality of second redistribution patterns 430 are formed. The plurality of conductive protective layers 420 fill the lower portions of the plurality of second via holes, and the plurality of second redistribution vias 434 may fill the remaining portions of the plurality of second via holes. That is, the plurality of second redistribution vias 434 fill all upper portions of the plurality of second via holes.

The second wiring structure 400 is obtained by repeatedly forming the plurality of second redistribution insulating layers 410 and the plurality of second redistribution patterns 430. In some embodiments, the bottom surfaces of the plurality of conductive protective layers 420 and the bottom surface of the lowermost second redistribution insulating layer 410 are coplanar. In some embodiments, the plurality of second bottom connection pads 430P2 protrude from the top surface of the uppermost second redistribution insulating layer 410.

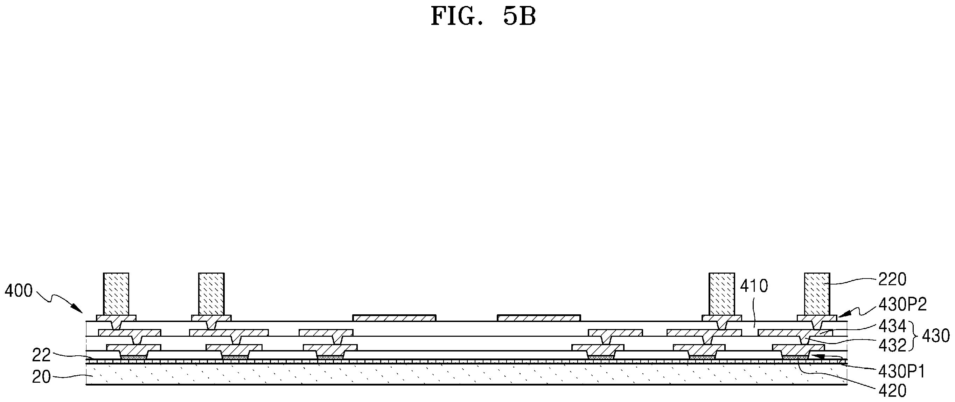

Compared to the second wiring structure 400 illustrated in FIG. 1, the second wiring structure 400 illustrated in FIG. 5A is turned upside down. FIGS. 5A and 5B show that the plurality of second bottom connection pads 430P2 face upward and the plurality of second top connection pads 430P1 face downward.

Referring to FIG. 5B, in an embodiment, the plurality of upper connection structures 220 are formed on some of the plurality of second bottom connection pads 430P2. In some embodiments, the plurality of upper connection structures 220 are obtained by forming a mask pattern that exposes parts of some of the plurality of second bottom connection pads 430P2 on the second wiring structure 400, and performing a plating process on the exposed parts of the some of the plurality of second bottom connection pads 430P2. After forming the plurality of upper connection structures 220, the mask pattern is removed.

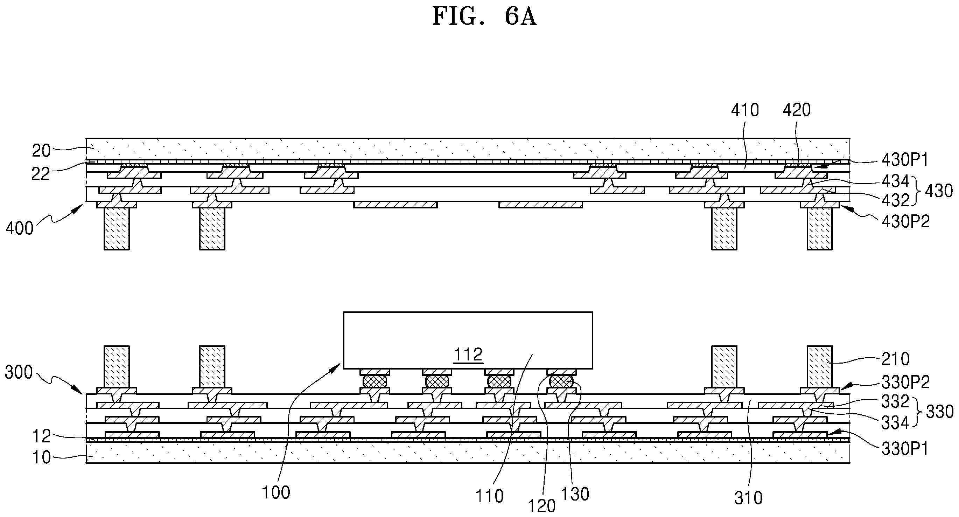

Referring to FIG. 6A, in an embodiment, the result of FIG. 4C and the result of FIG. 5B, now turned upside down, are prepared. For example, the first wiring structure 300, in which the plurality of lower connection structures 210 are formed and to which the semiconductor chip 100 is attached, and the second wiring structure 400, in which the plurality of upper connection structures 220 are formed, are prepared. The second wiring structure 400 is turned upside down so that the plurality of upper connection structures 220 face downward and the second wiring structure 400 faces upward.

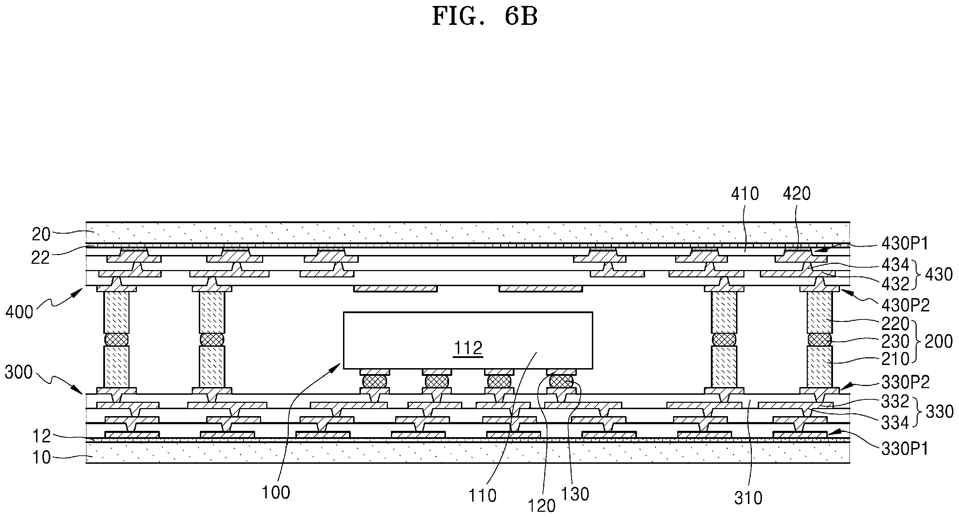

Referring to FIG. 6B, in an embodiment, the second wiring structure 400 is attached onto the first wiring structure 300 so that the plurality of lower connection structures 210 are electrically connected to the plurality of upper connection structures 220 with the plurality of conductive connection layers 230 between the plurality of lower connection structures 210 and the plurality of upper connection structures 220. The plurality of lower connection structures 210, the plurality of upper connection structures 220, and the plurality of conductive connection layers 230 configure the plurality of connection structures 200.

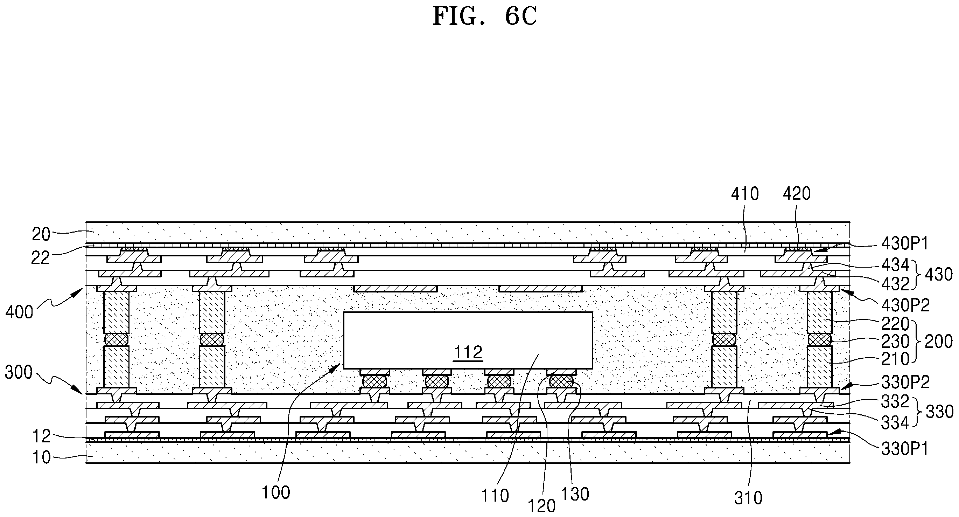

Referring to FIG. 6C, in an embodiment, the encapsulant 250 is formed that fills the space between the first wiring structure 300 and the second wiring structure 400. The encapsulant 250 surrounds the semiconductor chip 100 and the plurality of connection structures 200 on the top surface of the first wiring structure 300. In some embodiments, the encapsulant 250 has the MUF structure that fills the space between the bottom surface of the semiconductor chip 100 and the top surface of the first wiring structure 300 and surrounds the plurality of chip connection members 130.

The encapsulant 250 covers the side surfaces and at least a part of the top surface of each of the plurality of first top connection pads 330P2, and the side surfaces and at least a part of the bottom surface of each of the plurality of second bottom connection pads 430P2.

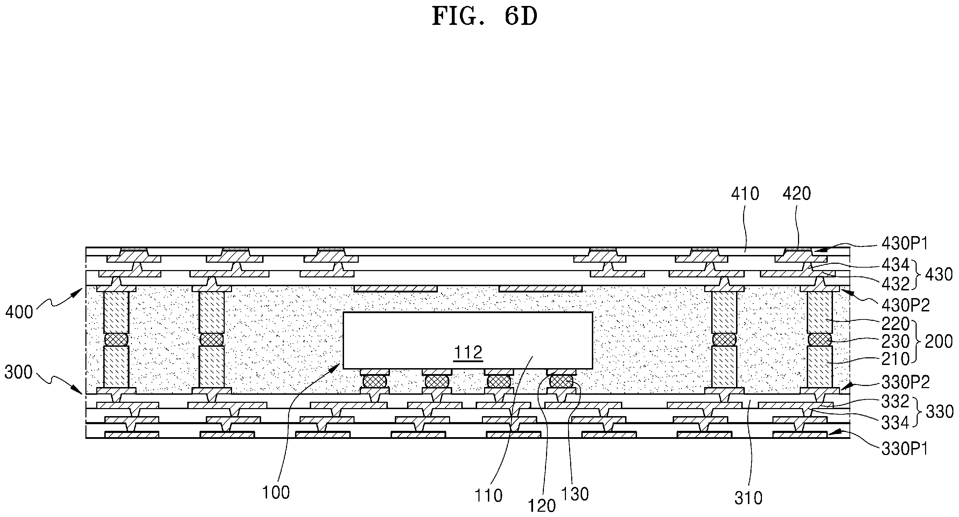

Referring to FIGS. 6C and 6D, in an embodiment, the first support substrate 10, on which the first base layer 12 is formed, and the second support substrate 20, on which the second base layer 22 is formed, are removed from the result of FIG. 6C. For example, the first support substrate 10 and the first base layer 12 are removed from the first wiring structure 300, and the second support substrate 20 and the second base layer 22 are removed from the second wiring structure 400.

Then, as illustrated in FIG. 1, the semiconductor package 1000 is formed by attaching the plurality of external connection terminals 500 to the plurality of first bottom connection pads 330P1.

Referring to FIGS. 1 to 6D together, the semiconductor package 1000 according to an embodiment of the inventive concept is obtained by separately forming the first wiring structure 300 and the second wiring structure 400 and attaching the second wiring structure 400 onto the first wiring structure 300. In addition, the semiconductor package 1000 according to an embodiment of the inventive concept is formed by attaching the semiconductor chip 100 onto the first wiring structure 300 and then, attaching the second wiring structure 400 onto the first wiring structure 300.

For example, forming the plurality of second redistribution insulating layers 410 and the plurality of second redistribution patterns 430 in the second wiring structure 400 does not take extra time.

In addition, because a process of forming the plurality of second redistribution insulating layers 410 and the plurality of second redistribution patterns 430 in the second wiring structure 400 on the first wiring structure 300 is not required, defects can be prevented from occurring in the semiconductor chip 100 while forming the plurality of second redistribution insulating layers 410 or the plurality of second redistribution patterns 430.

Accordingly, a manufacturing time of the semiconductor package 1000 can be reduced, and yield of the semiconductor package 1000 can be increased, so that productivity of a process of forming the semiconductor package 1000 according to an embodiment of the inventive concept is increased.

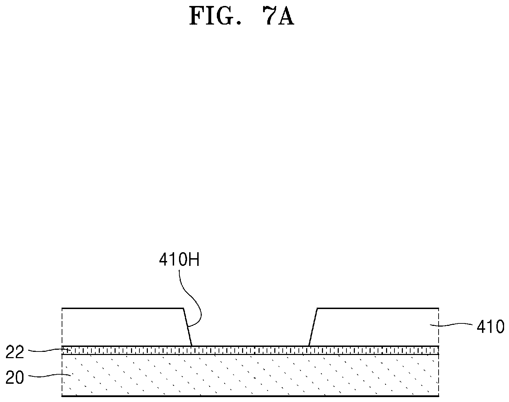

FIGS. 7A to 7D illustrate a method of manufacturing a semiconductor package 1000 according to embodiments. Specifically, FIGS. 7A to 7D are enlarged cross-sectional views that illustrate a method of manufacturing the semiconductor package 1000 illustrated in FIGS. 1 and 2A, and a portion corresponding to the portion II of FIG. 1.

Referring to FIGS. 5A and 7A together, in an embodiment, after forming the second preliminary redistribution insulating layer on the second support substrate 20 and the second base layer 22, an exposure process is performed that removes parts of the second preliminary redistribution insulating layer and forms the plurality of second redistribution insulating layers 410 and the plurality of second via holes 410H. The plurality of second via holes 410H are formed such that horizontal widths thereof decrease from the top surfaces of the plurality of second redistribution insulating layers 410 toward the bottom surfaces of the plurality of second redistribution insulating layers 410.

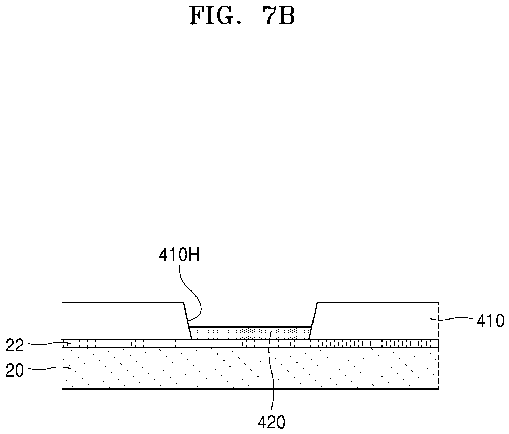

Referring to FIGS. 5A and 7B together, in an embodiment, the plurality of conductive protective layers 420 are formed that partially fill the lower portions of the plurality of second via holes 410H in the plurality of second redistribution insulating layers 410. In some embodiments, the bottom surfaces of the plurality of conductive protective layers 420 and the bottom surface of the lowermost second redistribution insulating layer 410 are coplanar.

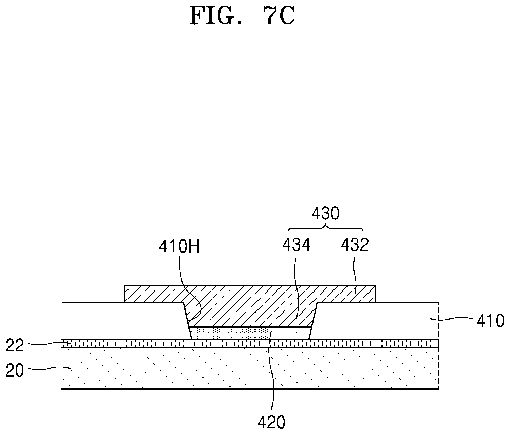

Referring to FIGS. 5A and 7C together, in an embodiment, after forming the plurality of second redistribution conductive layers that fill the plurality of second via holes 410H in the plurality of second redistribution insulating layers 410, the plurality of second redistribution conductive layers are patterned to form the plurality of second redistribution patterns 430, which include the plurality of second redistribution line patterns 432 and the plurality of second redistribution vias 434. The plurality of second redistribution vias 434 fill the plurality of second via holes 410H in the plurality of second insulating layers 410, and the plurality of second redistribution line patterns 432 are formed on the top surfaces of the plurality of second redistribution insulating layers 410. The plurality of second redistribution vias 434 are included in the plurality of second top connection pads 430P1.

Horizontal widths of the plurality of second redistribution vias 434 decrease from the top surfaces of the plurality of second redistribution insulating layers 410 toward the bottom surfaces of the plurality of second redistribution insulating layers 410. Because the plurality of second redistribution patterns 430, which includes the plurality of second redistribution line patterns 432 and the plurality of second redistribution vias 434, are formed by patterning the plurality of second redistribution conductive layers, at least some of the plurality of second redistribution line patterns 432 are integrated with at least some of the plurality of second redistribution vias 434.

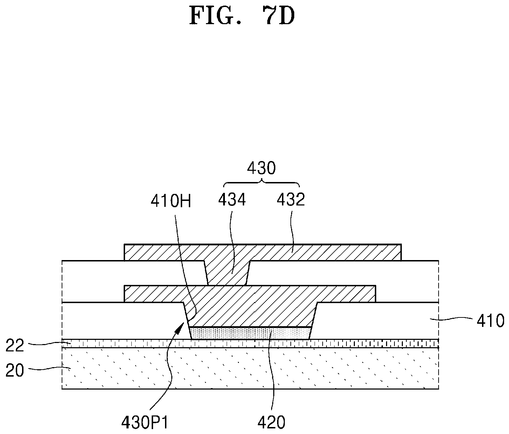

Referring to FIGS. 5A and 7D together, in an embodiment, the second wiring structure 400 illustrated in FIG. 5A is obtained by repeatedly forming the plurality of second redistribution insulating layers 410 and the plurality of second redistribution patterns 430.

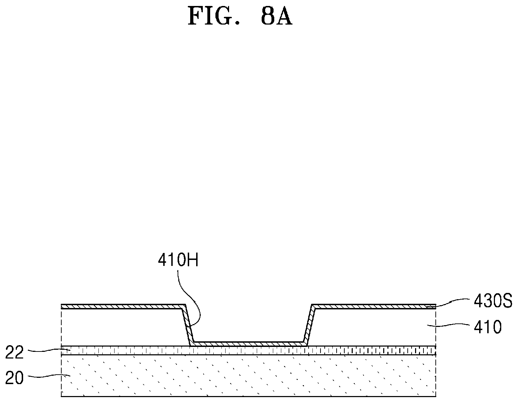

FIGS. 8A to 8F illustrate a method of manufacturing a semiconductor package 1000 according to embodiments. Specifically, FIGS. 8A to 8F are enlarged cross-sectional views that illustrate a method of manufacturing the semiconductor package 1000 illustrated in FIGS. 1 and 2B, and a portion corresponding to the portion II of FIG. 1.

Referring to FIGS. 5A and 8A together, in an embodiment, after forming the second preliminary redistribution insulating layer on the second support substrate 20 and the second base layer 22, an exposure process is performed that remove parts of the second preliminary redistribution insulating layer and forms the plurality of second redistribution insulating layers 410 and the plurality of second via holes 410H. The plurality of redistribution seed layers 430S are formed that conformally cover the top surfaces of the plurality of second redistribution insulating layers 410 and internal surfaces and bottom surfaces of the plurality of second via holes 410H, such as parts of the plurality of second redistribution insulating layers 410 and the second base layer 22 that are exposed by the plurality of second via holes 410H.

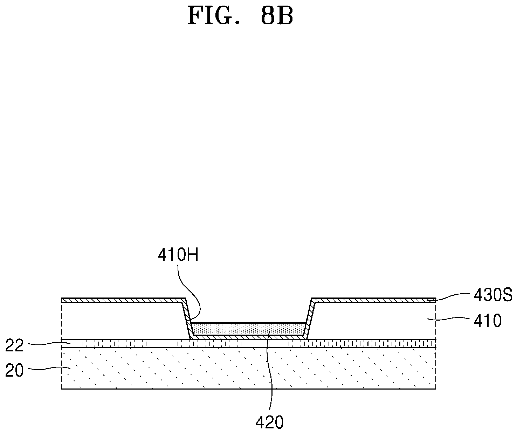

Referring to FIGS. 5A and 8B together, in an embodiment, the plurality of conductive protective layers 420 are formed that partially fill the lower portions of the plurality of second via holes 410H in the plurality of second redistribution insulating layers 410. The plurality of conductive protective layers 420 cover parts of the plurality of redistribution seed layers 430S and partially fill the lower portions of the plurality of second via holes 410H.

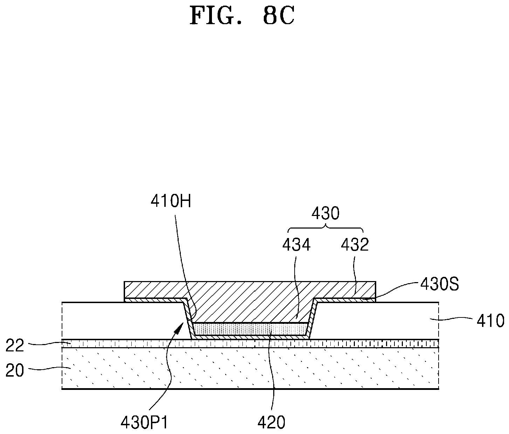

Referring to FIGS. 5A and 8C together, in an embodiment, after forming the plurality of second redistribution conductive layers that fill the plurality of second via holes 410H, the plurality of second redistribution conductive layers are patterned to form the plurality of second redistribution patterns 430, which include the plurality of second redistribution line patterns 432 and the plurality of second redistribution vias 434. The plurality of second redistribution vias 434 fill the remaining portions of the plurality of second via holes 410H, such as the upper portions of the plurality of second via holes 410H.

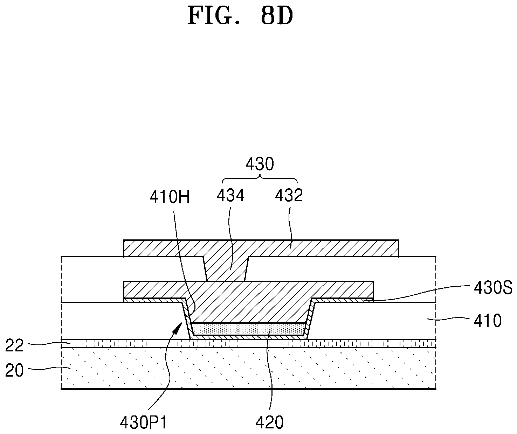

Referring to FIGS. 5A and 8D together, in an embodiment, the second wiring structure 400 illustrated in FIG. 5A is obtained by repeatedly forming the plurality of second redistribution insulating layers 410 and the plurality of second redistribution patterns 430.

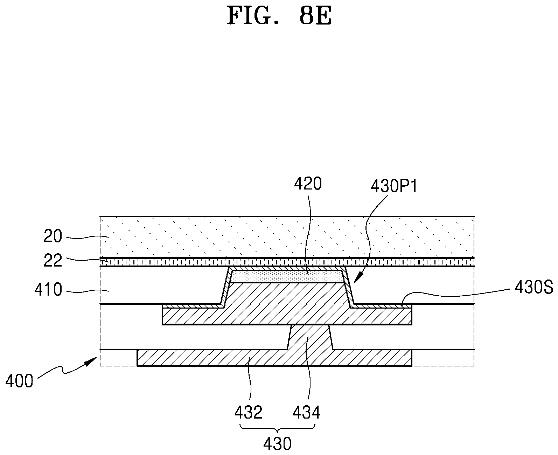

Referring to FIGS. 6A and 8E together, the second wiring structure 400 is turned upside down. As illustrated in FIGS. 6B and 6C, the second wiring structure 400 is attached onto the first wiring structure 300, and the encapsulant 250 is formed that fills the space between the first wiring structure 300 and the second wiring structure 400.

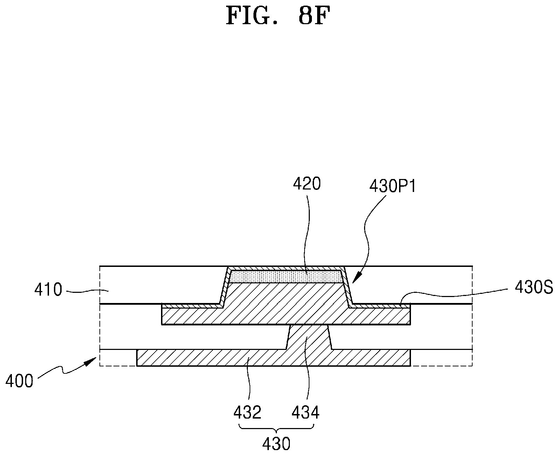

Referring to FIGS. 6D, 8E, and 8F together, in an embodiment, the second support substrate 20 and the second base layer 22 are removed from the second wiring structure 400.

Then, as illustrated in FIG. 2B, parts of the plurality of redistribution seed layers 430S, which cover the top surfaces of the plurality of conductive protective layers 420, are removed so that a vertical level of the top surface of each of the plurality of conductive protective layers 420 is lower than the top surface of the uppermost second redistribution insulating layer 410.

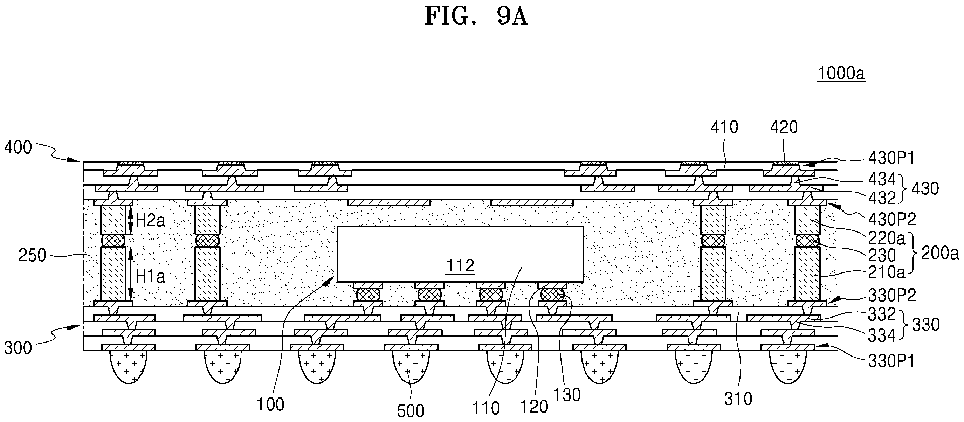

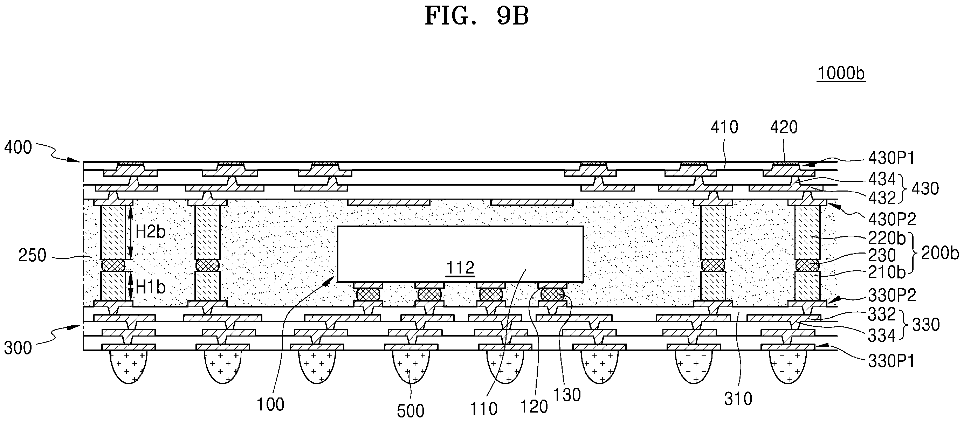

FIGS. 9A and 9B are cross-sectional views of semiconductor packages 1000a and 1000b according to embodiments.

Referring to FIG. 9A, in an embodiment, the semiconductor package 1000a includes a plurality of connection structures 200a instead of the plurality of connection structures 200 in the semiconductor package 1000 illustrated in FIG. 1.

The plurality of connection structures 200a include a plurality of lower connection structures 210a, a plurality of upper connection structures 220a, and a plurality of conductive connection layers 230. The plurality of conductive connection layers 230 are interposed between the plurality of lower connection structures 210a and the plurality of upper connection structures 220a and electrically connect the plurality of lower connection structures 210a to the plurality of upper connection structures 220a.

In some embodiments, each of the plurality of lower connection structures 210a and the plurality of upper connection structures 220a includes a conductive post that includes Cu or a Cu alloy. The plurality of conductive connection layers 230 contact top surfaces of the plurality of lower connection structures 210a and bottom surfaces of the plurality of upper connection structures 220a.

The plurality of lower connection structures 210a are attached onto the plurality of first top connection pads 330P2. For example, bottom surfaces of the plurality of lower connection structures 210a contact top surfaces of the plurality of first top connection pads 330P2. The plurality of upper connection structures 220a are attached onto the plurality of second bottom connection pads 430P2. For example, top surfaces of the plurality of upper connection structures 220a contact bottom surfaces of the plurality of second bottom connection pads 430P2. The encapsulant 250 covers side surfaces of the plurality of lower connection structures 210a, the plurality of upper connection structures 220a, and the plurality of conductive connection layers 230.

Each of the plurality of lower connection structures 210a has a first height H1a, and each of the plurality of upper connection structures 220a has a second height H2a. The first height H1a is greater than the second height H2a. Each of the plurality of conductive connection layers 230 is located at the same vertical level as the semiconductor chip 100.

Referring to FIG. 9B, in an embodiment, the semiconductor package 1000b includes a plurality of connection structures 200b instead of the plurality of connection structures 200 in the semiconductor package 1000 illustrated in FIG. 1.

The plurality of connection structures 200b include a plurality of lower connection structures 210b, a plurality of upper connection structures 220b, and a plurality of conductive connection layers 230. The plurality of conductive connection layers 230 are interposed between the plurality of lower connection structures 210b and the plurality of upper connection structures 220b and electrically connect the plurality of lower connection structures 210b to the plurality of upper connection structures 220b.

In some embodiments, each of the plurality of lower connection structures 210b and the plurality of upper connection structures 220b includes a conductive post that includes Cu or a Cu alloy. The plurality of conductive connection layers 230 contact top surfaces of the plurality of lower connection structures 210b and bottom surfaces of the plurality of upper connection structures 220b.

The plurality of lower connection structures 210b are attached onto the plurality of first top connection pads 330P2. For example, bottom surfaces of the plurality of lower connection structures 210b contact top surfaces of the plurality of first top connection pads 330P2. The plurality of upper connection structures 220b are attached onto the plurality of second bottom connection pads 430P2. For example, top surfaces of the plurality of upper connection structures 220b contact bottom surfaces of the plurality of second bottom connection pads 430P2. The encapsulant 250 covers side surfaces of the plurality of lower connection structures 210b, the plurality of upper connection structures 220b, and the plurality of conductive connection layers 230.

Each of the plurality of lower connection structures 210b has a first height Hlb, and each of the plurality of upper connection structures 220b has a second height H2b. The second height H2b is greater than the first height H1b. Each of the plurality of conductive connection layers 230 is located at the same vertical level as the semiconductor chip 100.

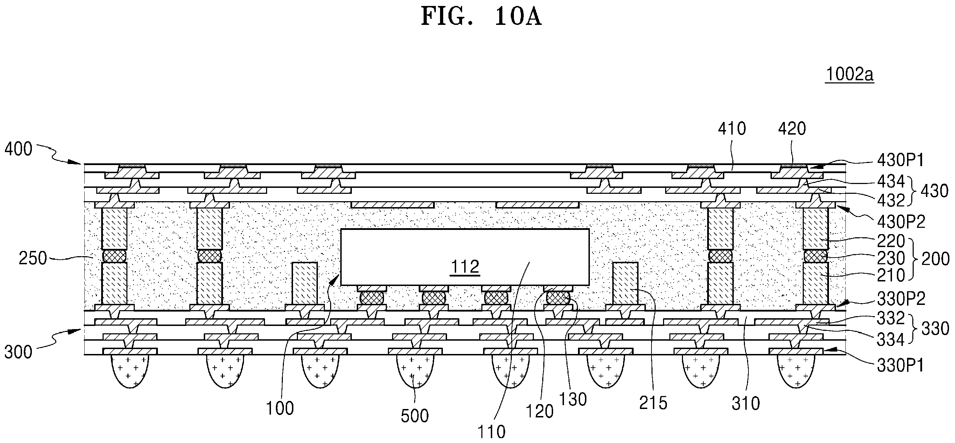

FIGS. 10A to 10E are cross-sectional views of semiconductor packages 1002a, 1002b, 1002c, 1002d, and 1002e according to embodiments.

Referring to FIG. 10A, in an embodiment, the semiconductor package 1002a further includes at least one lower dummy conductive structure 215. Because the semiconductor package 1002a is substantially the same as the semiconductor package 1000 illustrated in FIG. 1 except for the at least one lower dummy conductive structure 215, description previously given with reference to FIG. 1 will be omitted.

The at least one lower dummy conductive structure 215 is attached to at least one of a plurality of first top connection pads 330P2. The at least one lower dummy conductive structure 215 is formed together with a plurality of lower connection structures 210. A height of the at least one lower dummy conductive structure 215 is substantially equal to that of each of the plurality of lower connection structures 210. The at least one lower dummy conductive structure 215 extends from a first wiring structure 300 into an encapsulant 250.

Top surfaces of the plurality of lower connection structures 210 contact a plurality of conductive connection layers 230, and the plurality of conductive connection layers 230 contact bottom surfaces of a plurality of upper connection structures 220 so that the plurality of lower connection structures 210 are electrically connected to the plurality of upper connection structures 220. However, a top surface of the at least one lower dummy conductive structure 215 does not contact the plurality of conductive connection layers 230, but contacts the encapsulant 250. For example, a bottom surface of the at least one lower dummy conductive structure 215 contacts the at least one of the plurality of first top connection pads 330P2, and side surfaces and the top surface of the at least one lower dummy conductive structure 215 contact the encapsulant 250. For example, the at least one lower dummy conductive structure 215 is surrounded by both the at least one of the plurality of first top connection pads 330P2 and the encapsulant 250.

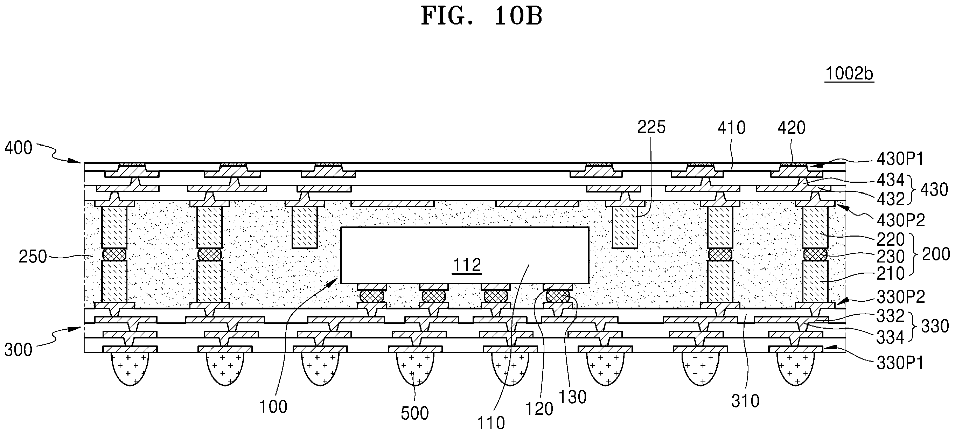

Referring to FIG. 10B, in an embodiment, the semiconductor package 1002b further includes at least one upper dummy conductive structure 225. Because the semiconductor package 1002b is substantially the same as the semiconductor package 1000 illustrated in FIG. 1, except for the at least one upper dummy conductive structure 225, description previously given with reference to FIG. 1 will be omitted.

The at least one upper dummy conductive structure 225 is attached to at least one of a plurality of second bottom connection pads 430P2. The at least one upper dummy conductive structure 225 is formed together with a plurality of upper connection structures 220. A height of the at least one upper dummy conductive structure 225 is substantially equal to that of each of the plurality of upper connection structures 220. The at least one upper dummy conductive structure 225 extends from a second wiring structure 400 into an encapsulant 250.

Bottom surfaces of the plurality of upper connection structures 220 contact a plurality of conductive connection layers 230, and the plurality of conductive connection layers 230 contact top surfaces of a plurality of lower connection structures 210 so that the plurality of lower connection structures 210 are electrically connected to the plurality of upper connection structures 220. However, a bottom surface of the at least one upper dummy conductive structure 225 does not contact the plurality of conductive connection layers 230, but contacts the encapsulant 250. For example, a top surface of the at least one upper dummy conductive structure 225 contacts the at least one of the plurality of second bottom connection pads 430P2, and side surfaces and the bottom surface of the at least one upper dummy conductive structure 225 contact the encapsulant 250. For example, the at least one upper dummy conductive structure 225 is surrounded by both the at least one of the plurality of second bottom connection pads 430P2 and the encapsulant 250.

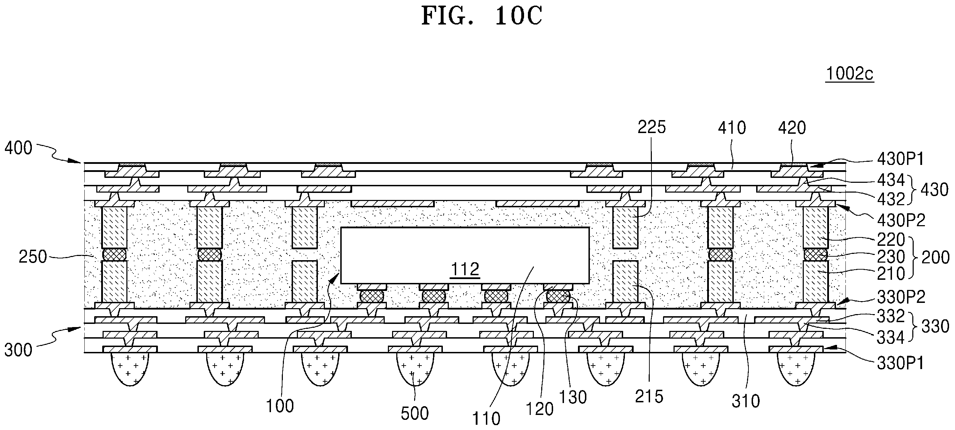

Referring to FIG. 10C, the semiconductor package 1002c further includes at least one lower dummy conductive structure 215 and at least one upper dummy conductive structure 225. Because the at least one lower dummy conductive structure 215 and the at least one upper dummy conductive structure 225 illustrated in FIG. 10C are substantially the same as the at least one lower dummy conductive structure 215 illustrated in FIG. 10A and the at least one upper dummy conductive structure 225 illustrated in FIG. 10B, description previously given with reference to FIGS. 10A and 10B will be omitted.

In some embodiments, the semiconductor package 1002c includes the same number of lower dummy conductive structures 215 and upper dummy conductive structures 225. FIG. 10C shows that the semiconductor package 1002c includes two lower dummy conductive structures 215 and two upper dummy conductive structures 225. However, embodiments of the inventive concept are not necessarily limited thereto. For example, in some embodiments, the semiconductor package 1002c includes one lower dummy conductive structure 215 and one upper dummy conductive structure 225, or three or more lower dummy conductive structures 215 and three or more upper dummy conductive structures 225.

In some embodiments, the at least one lower dummy conductive structure 215 and the at least one upper dummy conductive structure 225 in the semiconductor package 1002c are respectively attached to a first wiring structure 300 and a second wiring structure 400 and aligned with each other in the vertical direction. However, embodiments of the inventive concept are not necessarily limited thereto. For example, in some embodiments, the at least one lower dummy conductive structure 215 and the at least one upper dummy conductive structure 225 are respectively attached to a part of the first wiring structure 300 and a part of the second wiring structure 400 that do not overlap in the vertical direction so that the at least one lower dummy conductive structure 215 and the at least one upper dummy conductive structure 225 are not aligned with each other in the vertical direction.

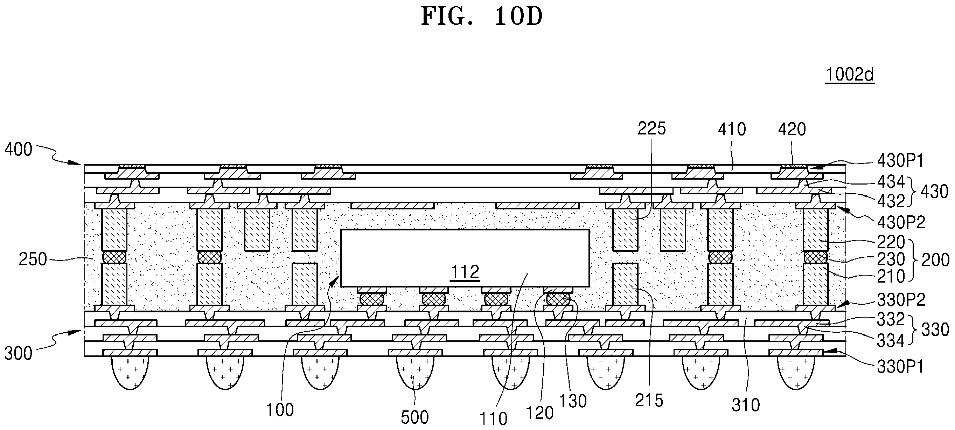

Referring to FIG. 10D, in an embodiment, the semiconductor package 1002d further includes at least one lower dummy conductive structure 215 and a plurality of upper dummy conductive structures 225. Because the at least one lower dummy conductive structure 215 and the plurality of upper dummy conductive structures 225 illustrated in FIG. 10D are substantially the same as the at least one lower dummy conductive structure 215 illustrated in FIG. 10A and the at least one upper dummy conductive structure 225 illustrated in FIG. 10B, description previously given with reference to FIGS. 10A and 10B will be omitted.

In some embodiments, the number of upper dummy conductive structures 225 in the semiconductor package 1002d is greater than that of lower dummy conductive structures 215 in the semiconductor package 1002d. FIG. 10D shows that the semiconductor package 1002d includes two lower dummy conductive structures 215 and four upper dummy conductive structures 225. However, embodiments of the inventive concept are not necessarily limited thereto. For example, in some embodiments, the semiconductor package 1000d includes one lower dummy conductive structure 215 or three or more lower dummy conductive structures 215, and three upper dummy conductive structures 225 or five or more upper dummy conductive structures 225.

In some embodiments, at least one of the plurality of upper dummy conductive structures 225 in the semiconductor package 1002d is vertically aligned with at least one lower dummy conductive structure 215. However, embodiments of the inventive concept are not necessarily limited thereto. For example, in some embodiments, the at least one lower dummy conductive structure 215 and the plurality of upper dummy conductive structures 225 are attached to a part of the first wiring structure 300 and parts of the second wiring structure 400 that do not overlap in the vertical direction, so that the at least one lower dummy conductive structure 215 and the plurality of upper dummy conductive structures 225 are not aligned with each other in the vertical direction.

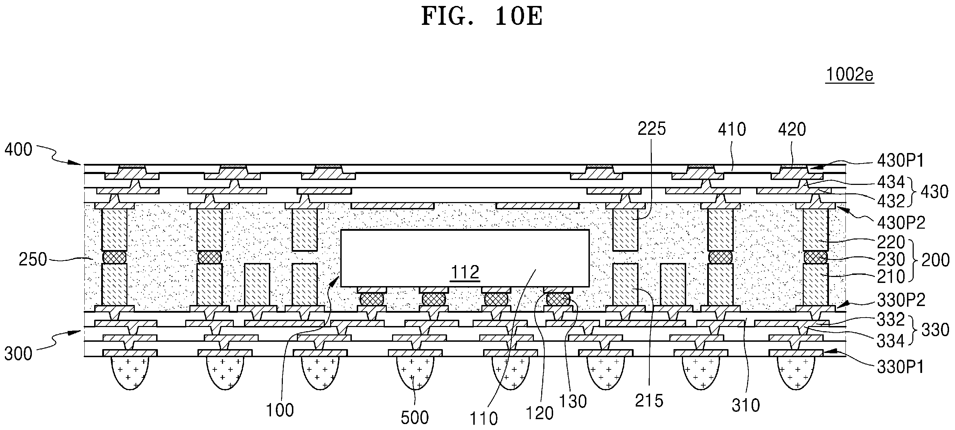

Referring to FIG. 10E, in an embodiment, the semiconductor package 1002e further includes a plurality of lower dummy conductive structures 215 and at least one upper dummy conductive structure 225. Because the plurality of lower dummy conductive structures 215 and the at least one upper dummy conductive structure 225 illustrated in FIG. 10E are substantially the same as the at least one lower dummy conductive structure 215 illustrated in FIG. 10A and the at least one upper dummy conductive structure 225 illustrated in FIG. 10B, description previously given with reference to FIGS. 10A and 10B will be omitted.

In some embodiments, the number of lower dummy conductive structures 215 in the semiconductor package 1002e is greater than that of upper dummy conductive structures 225 in the semiconductor package 1002e. FIG. 10E shows that the semiconductor package 1002e includes four lower dummy conductive structures 215 and two upper dummy conductive structures 225. However, embodiments of the inventive concept are not necessarily limited thereto. For example, in some embodiments, the semiconductor package 1002e includes three lower dummy conductive structures 215 or five or more lower dummy conductive structures 215, and one upper dummy conductive structure 225 or three or more upper dummy conductive structures 225.

In some embodiments, at least one of the plurality of lower dummy conductive structures 215 in the semiconductor package 1002e is vertically aligned with the at least one upper dummy conductive structure 225. However, embodiments of the inventive concept are not necessarily limited thereto. For example, in some embodiments, the plurality of lower dummy conductive structures 215 and the at least one upper dummy conductive structure 225 are attached to parts of the first wiring structure 300 and a part of the second wiring structure 400 that do not overlap in the vertical direction, so that the plurality of lower dummy conductive structures 215 and the at least one upper dummy conductive structure 225 are not aligned with each other in the vertical direction.

FIGS. 10A to 10E show that the semiconductor packages 1002a, 1002b, 1002c, 1002d, and 1002e include the plurality of lower dummy conductive structures 215 formed with the plurality of lower connection structures 210 and each having a height substantially equal to that of each of the plurality of lower connection structures 210, and/or the plurality of upper dummy conductive structures 225 formed with the plurality of upper connection structures 220 and each having a height substantially equal to that of each of the plurality of upper connection structures 220. However, embodiments of the inventive concept are not necessarily limited thereto. For example, in some embodiments, the plurality of lower dummy conductive structures and/or the plurality of upper dummy conductive structures of the semiconductor packages 1002a, 1002b, 1002c, 1002d, and 1002e are respectively formed with the plurality of lower connection structures 210a and the plurality of upper connection structures 220a illustrated in FIG. 9A, and each has a height substantially equal to that of each of the plurality of lower connection structures 210a and the plurality of upper connection structures 220a, respectively. Similarly, the plurality of lower dummy conductive structures and/or the plurality of upper dummy conductive structures are respectively formed with the plurality of lower connection structures 210b and the plurality of upper connection structures 220b illustrated in FIG. 9B, and each has a height substantially equal to that of each of the plurality of lower connection structures 210b and the plurality of upper connection structures 220b, respectively.

Referring to FIGS. 10A to 10E together, the semiconductor packages 1002a, 1002b, 1002c, 1002d, and 1002e according to embodiments of the inventive concept include the plurality of lower dummy conductive structures 215, the plurality of upper dummy conductive structures 225, or the plurality of lower dummy conductive structures 215 and the plurality of upper dummy conductive structures 225 together.

The plurality of lower dummy conductive structures 215 attached to the first wiring structure 300 and the plurality of upper dummy conductive structures 225 attached to the second wiring structure 400 prevent warpage from occurring in the semiconductor packages 1002a, 1002b, 1002c, 1002d, and 1002e that include the first wiring structure 300 and/or the second wiring structure 400 by controlling a thermal expansion coefficient that between the first wiring structure 300 and the second wiring structure 400. For example, because the plurality of lower dummy conductive structures 215 and the plurality of upper dummy conductive structures 225 are respectively attached to parts of the first wiring structure 300 and the second wiring structure 400 as occasion demands, the plurality of lower dummy conductive structures 215 and the plurality of upper dummy conductive structures 225 can effectively prevent warpage from occurring in the semiconductor packages 1002a, 1002b, 1002c, 1002d, and 1002e by controlling warpage that may partially occur in the first wiring structure 300 and/or the second wiring structure 400, respectively.

In addition, because each of the plurality of lower dummy conductive structures 215 and the plurality of upper dummy conductive structures 225 has a thermal conductivity higher than that of the encapsulant 250, heat generated by the semiconductor chip 100 is emitted out from the semiconductor packages 1002a, 1002b, 1002c, 1002d, and 1002e. For example, because the plurality of lower dummy conductive structures 215 and the plurality of upper dummy conductive structures 225 are respectively attached to parts of the first wiring structure 300 and the second wiring structure 400 as occasion demands, heat partially generated by the semiconductor packages 1002a, 1002b, 1002c, 1002d, and 1002e is effectively emitted.

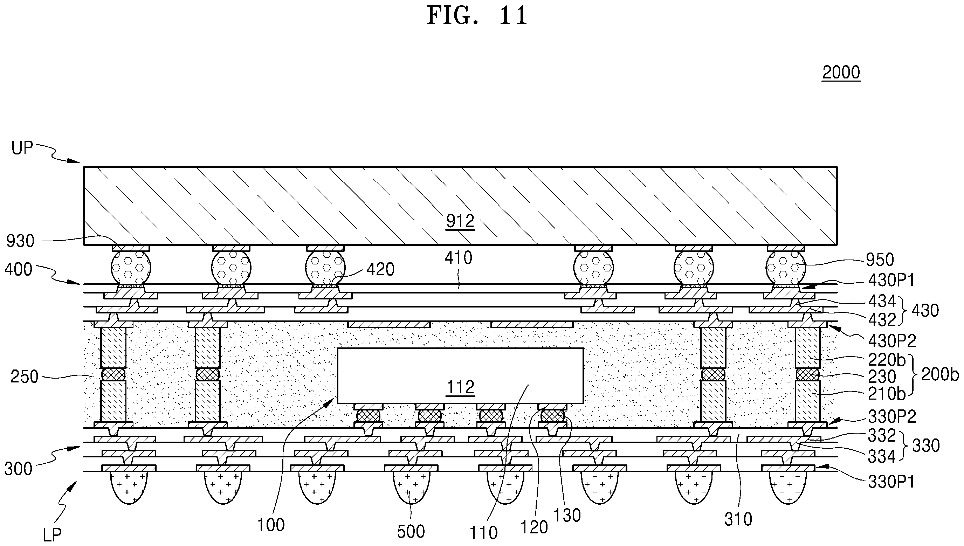

FIG. 11 is a cross-sectional view of a semiconductor package 2000 according to embodiments.

Referring to FIG. 11, in an embodiment, the semiconductor package 2000 includes a lower package LP and an upper package UP attached to the lower package LP. The semiconductor package 2000 may be a PoP. The lower package LP includes the semiconductor package 1000 illustrated in FIG. 1. However, embodiments of the inventive concept are not necessarily limited thereto. For example, in other embodiments, the lower package LP includes one of the semiconductor packages 1002a, 1002b, 1002c, 1002d, and 1002e illustrated in FIGS. 9A to 10E.

The upper package UP includes an upper semiconductor chip that includes an upper semiconductor device 912 and a plurality of upper connection pads 930. The upper package UP is electrically connected to the lower package LP by a plurality of package connection terminals 950 interposed between the plurality of upper connection pads 930 and the plurality of second top connection pads 430P1. For example, the upper package UP is electrically connected to the plurality of first redistribution patterns 330 of the first wiring structure 300 through the plurality of package connection terminals 950 attached to the plurality of upper connection pads 930, the plurality of second redistribution patterns 430, and the plurality of connection structures 200. In some embodiments, the upper semiconductor device 912 includes a memory device, and the upper semiconductor chip include a memory semiconductor chip. For example, the memory device includes a non-volatile memory device such as one of a flash memory, a PRAM, an MRAM, an FeRAM, and an RRAM. In some embodiments, the memory device includes a volatile memory device such as a DRAM or an SRAM.

The upper package UP may include one upper semiconductor chip or a plurality of upper semiconductor chips. The upper semiconductor chip may be mounted in the upper package UP in a flip chip manner, or may be electrically connected to the upper package UP through a bonding wire that is mounted in the upper package UP by using a die attach film (DAF). The upper package UP may include a plurality of upper semiconductor chips that are spaced apart from one another in the horizontal direction, or a plurality of upper semiconductor chips stacked in the vertical direction. Alternatively, the upper package UP may include a plurality of upper semiconductor chips electrically connected through a through electrode and stacked in the vertical direction. Alternatively, the upper package UP may include one semiconductor chip.

For example, the upper package UP may include any type of semiconductor package that includes at least one upper semiconductor chip that has the upper semiconductor device 912, and the plurality of upper connection pads 930 to be electrically connected to the lower package LP.

While embodiments of the inventive concept have been particularly shown and described with reference to the drawings, it will be understood that various changes in form and details may be made therein without departing from the scope of the following claims.

## Claims

1. A semiconductor package, comprising:
a first wiring structure that includes a plurality of first redistribution patterns that include a plurality of first bottom connection pads and a plurality of first top connection pads, and a plurality of first redistribution insulating layers that surround the plurality of first redistribution patterns;
a second wiring structure that includes a plurality of second redistribution patterns that include a plurality of second bottom connection pads and a plurality of second top connection pads, and a plurality of second redistribution insulating layers that surround the plurality of second redistribution patterns;
a semiconductor chip interposed between the first wiring structure and the second wiring structure;
an encapsulant that fills a space between the first wiring structure and the second wiring structure and that surrounds the semiconductor chip; and
a plurality of connection structures that penetrate through the encapsulant and connect the plurality of first top connection pads to the plurality of second bottom connection pads and are arranged around the semiconductor chip, wherein the plurality of connection structures include a plurality of lower connection structures of which bottom surfaces contact top surfaces of the plurality of first top connection pads, a plurality of upper connection structures of which top surfaces contact bottom surfaces of the plurality of second bottom connection pads, and a plurality of conductive connection layers that contact top surfaces of the plurality of lower connection structures and bottom surfaces of the plurality of upper connection structures.

2. The semiconductor package of claim 1,
wherein the plurality of first redistribution patterns include a plurality of first redistribution line patterns and a plurality of first redistribution via patterns,
wherein the plurality of second redistribution patterns include a plurality of second redistribution line patterns and a plurality of second redistribution via patterns, and
wherein the plurality of first redistribution via patterns and the plurality of second redistribution via patterns are tapered wherein horizontal widths thereof decrease in directions opposite to each other in a vertical direction.

3. The semiconductor package of claim 2,
wherein horizontal widths of the plurality of first redistribution via patterns and the plurality of second redistribution via patterns increase toward the semiconductor chip.

4. The semiconductor package of claim 1 or 2,
wherein the plurality of first top connection pads protrude from top surfaces of the plurality of first redistribution insulating layers,
wherein the plurality of second bottom connection pads protrude from bottom surfaces of the plurality of second redistribution insulating layers, and
wherein the encapsulant covers side surfaces and at least a part of a top surface of each of the plurality of first top connection pads and side surfaces and at least a part of a bottom surface of each of the plurality of second bottom connection pads.

5. The semiconductor package of any one of claims 1 to 4, wherein bottom surfaces of the plurality of first bottom connection pads and a bottom surface of a lowermost first redistribution insulating layer of the plurality of first redistribution insulating layers are coplanar.

6. The semiconductor package of any one of claims 1 to 5, further comprising:
a plurality of conductive protective layers that cover the plurality of second top connection pads,
wherein a top surface of each of the plurality of conductive protective layers is coplanar with or lower than that of a top surface of an uppermost second redistribution insulating layer.

7. The semiconductor package of any one of claims 1 to 6, further comprising at least one of:
a lower dummy conductive structure that has a height equal to that of each of the plurality of lower connection structures, extends from the first wiring structure into the encapsulant, and has a top surface in contact with the encapsulant; and
an upper dummy conductive structure that has a height equal to that of each of the plurality of upper connection structures, extends from the second wiring structure into the encapsulant, and has a bottom surface in contact with the encapsulant.

8. The semiconductor package of claim 7, further comprising one or more lower dummy conductive structures and one or more upper dummy conductive structures, wherein a number of lower dummy conductive structures differs from a number of upper dummy conductive structures.

9. The semiconductor package of any one of claims 1 to 8, wherein at least a part of the plurality of conductive connection layers is at a same vertical level as the semiconductor chip.

10. A semiconductor package of claim 1, wherein:
the semiconductor chip is attached onto the first wiring structure,
the second wiring structure is disposed on the first wiring structure and the semiconductor chip,
the plurality of lower connection structures are attached to the plurality of first top connection pads,
the plurality of upper connection structures are attached to the plurality of second bottom connection pads,
the plurality of conductive connection layers are interposed between the plurality of lower connection structures and the plurality of upper connection structures and connect the first wiring structure to the second wiring structure,
the encapsulant surrounds the plurality of connection structures,
the plurality of first top connection pads protrude from top surfaces of the plurality of first redistribution insulating layers and the plurality of second bottom connection pads protrude from bottom surfaces of the plurality of second redistribution insulating layers, and
wherein the encapsulant covers side surfaces and at least a part of a top surface of each of the plurality of first top connection pads and side surfaces and at least a part of a bottom surface of each of the plurality of second bottom connection pads.

11. The semiconductor package of claim 10, wherein a height of each of the plurality of lower connection structures is equal to that of each of the plurality of upper connection structures.

12. The semiconductor package of claim 10, wherein a height of each of the plurality of lower connection structures differs from that of each of the plurality of upper connection structures.

13. The semiconductor package of any one of claims 10 to 12, further comprising:
a lower dummy conductive structure that has a height equal to that of each of the plurality of lower connection structures, extends from the first wiring structure into the encapsulant, and includes a top surface in contact with the encapsulant; and
an upper dummy conductive structure that has a height equal to that of each of the plurality of upper connection structures, extends from the second wiring structure into the encapsulant, and includes a bottom surface in contact with the encapsulant,
wherein the lower dummy conductive structure includes a plurality of lower dummy conductive structures, and the upper dummy conductive structure includes a plurality of upper dummy conductive structures, and
wherein a number of lower dummy conductive structures differs from a number of the upper dummy conductive structures.

14. The semiconductor package of any one of claims 10 to 13,
wherein the plurality of first redistribution patterns include a plurality of first redistribution line patterns and a plurality of first redistribution via patterns,
wherein the plurality of second redistribution patterns include a plurality of second redistribution line patterns and a plurality of second redistribution via patterns, and
wherein the plurality of first redistribution via patterns and the plurality of second redistribution via patterns are tapered such that horizontal widths thereof increase toward the semiconductor chip.

15. The semiconductor package of claim 1, wherein:
the plurality of first redistribution patterns include a plurality of first redistribution line patterns and a plurality of first redistribution via patterns,
the plurality of second redistribution patterns include a plurality of second redistribution line patterns and a plurality of second redistribution via patterns,
the plurality of connection structures are spaced apart from the semiconductor chip in a horizontal direction,
the plurality of lower connection structures are attached to the plurality of first top connection pads,
the plurality of upper connection structures are attached to the plurality of second bottom connection pads, and
the plurality of conductive connection layers are interposed between the plurality of lower connection structures and the plurality of upper connection structures, and electrically connect the plurality of first redistribution patterns to the plurality of second redistribution patterns,
the encapsulant surrounds the plurality of connection structures, and
the plurality of first redistribution via patterns and the plurality of second redistribution via patterns are tapered where horizontal widths thereof increase toward the semiconductor chip.
